# EUROPEAN PATENT APPLICATION

(11) **EP 3 780 129 A1**
(43) Date of publication of application: **17.02.2021**
(21) Application number: 18914571.7
(22) Date of filing: 10.04.2018
(51) Int. Cl.: H01L 51/44

(54) **LIGHT ABSORBING LAYER, PHOTOELECTRIC TRANSDUCER, AND SOLAR CELL**

(71) Applicant: Kao Corporation, Chuo-ku, Tokyo 103-8210 (JP)
(72) Inventor: HOSOKAWA, Hiroji, Wakayama-shi, Wakayama 640-8580 (JP); SAWADA, Takuya, Wakayama-shi, Wakayama 640-8580 (JP); OKONOGI, Akinori, Wakayama-shi, Wakayama 640-8580 (JP)
(74) Representative: Hoffmann Eitle
(86) International application number: PCT/JP2018/015118
(87) International publication number: WO 2019/198159

(57) **Abstract**

The present invention relates to a light absorption layer for forming a photoelectric conversion element and a solar cell that have excellent photoelectric conversion efficiencies; and a photoelectric conversion element and a solar cell that include the light absorption layer. This light absorption layer comprises quantum dots dispersed in a matrix of one or more perovskite compounds selected from a compound represented by the following general formula (1) and a compound represented by the following general formula (2) :

RMX₃ (1)

wherein R is two or more of monovalent cations, M is a divalent metal cation, and X is a halogen anion,

R¹R²R³ₙ₋₁MₙX₃ₙ₊₁ (2)

wherein R¹, R², and R³ are each independently a monovalent cation, at least two of R¹, R², and R³ are different monovalent cations, and at least one of R¹, R², and R³ is a monovalent inorganic cation, M is a divalent metal cation, X is a halogen anion, and n is an integer of 1 or more and 10 or less.

## Description

### TECHNICAL FIELD

The present invention relates to a light absorption layer, a photoelectric conversion element having the light absorption layer, and a solar cell having the photoelectric conversion element.

### BACKGROUND ART

A photoelectric conversion element that converts light energy into electric energy is used for solar cells, optical sensors, copying machines, and the like. In particular, from the viewpoint of environmental and energy problems, photoelectric conversion elements (solar cells) utilizing sunlight that is an inexhaustible clean energy attract attention.

Since general silicon solar cells utilize ultra-high purity silicon and are manufactured by "dry process" such as epitaxial crystal growth under high vacuum, it is not possible to expect a large cost reduction. Therefore, a solar cell manufactured by a "wet process" such as a coating process is expected as a low-cost next generation solar cell.

A quantum dot solar cell is a next-generation solar cell that can be manufactured by the "wet process". The quantum dot is an inorganic nanoparticle having a particle size of about 20 nm or less and exhibits physical properties different from those of bulk bodies due to the expression of quantum size effect. For example, it is known that the band gap energy increases (shortening of the absorption wavelength) as the particle size of quantum dots decreases, and lead sulfide (PbS) quantum dots having a particle size of about 3 nm and a band gap energy of about 1.2 eV have been reported for use in quantum dot solar cells (ACS Nano 2014, 8, 614-622).

In addition, there is a perovskite solar cell as the most promising candidate for the next generation solar cell, which has been recently reported to show a rapid increase in photoelectric conversion efficiency. This perovskite solar cell is provided with a photoelectric conversion element using a perovskite compound (CH₃NH₃PbI₃) composed of a cation (such as methyl ammonium) and a halogenated metal salt (such as lead iodide) for the light absorption layer (J. Am. Chem. Soc. 2009, 131, 6050-6051). It is known that the chemical and physical properties of the perovskite compound change depending on the composition of the cationic species, halogen element, metal element and the like. For example, it has been reported that by doping cesium into methylammonium as a cation species, the film thickness of the perovskite film is increased, so that the conversion efficiency due to increases in light absorption is improved (Nano Energy 2014, 7, 80-85).

Furthermore, in order to express photoelectric conversion in the near-infrared light region where the perovskite compound does not absorb light, a perovskite solar cell in which PbS quantum dots that absorb near infrared light are compounded has been reported (WO 2018/025445) .

### SUMMARY OF THE INVENTION

The present invention relates to a light absorption layer for forming a photoelectric conversion element and a solar cell that have excellent photoelectric conversion efficiencies; and a photoelectric conversion element and a solar cell that include the light absorption layer.

When the amount of quantum dots compounded with a perovskite compound (for example, CH₃NH₃PbI₃) is increased in order to improve the photoelectric conversion efficiency in the near infrared light region, the present inventors have found that a perovskite raw material having a low photoelectric conversion performance (for example, PbI₂) remains, resulting in causing a problem of a decrease in photoelectric conversion efficiency.

Then, the present inventors have found that even in the case where a perovskite compound containing two or more kinds of cation species is used to increase the amount of quantum dots to be compounded, the perovskite raw material is less likely to remain and a light absorption layer that expresses an excellent photoelectric conversion efficiency can be obtained.

That is, the present invention is related to a light absorption layer comprising quantum dots dispersed in a matrix of one or more perovskite compounds selected from a compound represented by the following general formula (1) and a compound represented by the following general formula (2) :

RMX₃ (1)

wherein R is two or more of monovalent cations, M is a divalent metal cation, and X is a halogen anion,

R¹R²R³ₙ₋₁MₙX₃ₙ₊₁ (2)

wherein R¹, R², and R³ are each independently a monovalent cation, at least two of R¹, R², and R³ are different monovalent cations, and at least one of R¹, R², and R³ is a monovalent inorganic cation, M is a divalent metal cation, X is a halogen anion, and n is an integer of 1 or more and 10 or less.

By using, as a material for forming the light absorption layer, a perovskite compound containing two or more kinds of cation species (for example, CH₃NH₃⁺ and Cs⁺), the perovskite raw material (for example, PbI₂) hardly remains even when the amount of quantum dots to be compounded is increased. As a result, a light absorption layer that expresses an excellent photoelectric conversion efficiency can be obtained. The reason for this is not clear but is presumed as follows. A perovskite compound (for example, CH₃NH₃PbI₃) is crystallized from a mixed solution of a metal halide (for example, PbI₂) that is a perovskite raw material and a halogenated cation (for example, CH₃NH₃I). It is presumed that when quantum dots coexist in the mixed solution, the reaction between the metal halide salt and the halogenated cation is inhibited, so that crystal precipitation of the perovskite compound is suppressed and the perovskite raw material (for example, PbI₂) remains. As in the present invention, when two or more kinds of halogenated cations (for example, CH₃NH₃I and CsI) containing two or more kinds of cation species (for example, CH₃NH₃⁺ and Cs⁺) are used, reaction adaptability with the metal halide salt is expanded. At the same time, as a result of stabilization of the crystal structure of the perovskite compound, it is presumed that the perovskite raw material (for example, PbI₂) is less likely to remain and thus a light absorption layer that expresses an excellent photoelectric conversion efficiency can be obtained. Furthermore, the presence of two or more cations at the interface between the perovskite and the quantum dot causes crystal structure distortion (crystal lattice mismatch) between the perovskite and the quantum dot and suppresses carrier transfer from the perovskite to the quantum dot. Therefore, there is a possibility that such a photoelectric conversion efficiency is improved.

According to the present invention, even when the content of quantum dots is increased, it is possible to obtain a light absorption layer, a photoelectric conversion element, and a solar cell which have a low content of a perovskite raw material having low photoelectric conversion performance and are excellent in photoelectric conversion efficiency.

The present inventors have also found a method for manufacturing a light absorption layer by a wet process utilizing a quantum dot solid having a specific ligand.

That is, the present invention is related to a method for manufacturing a light absorption layer comprising quantum dots dispersed in a matrix of one or more perovskite compounds selected from a compound represented by the following general formula (1) and a compound represented by the following general formula (2), and including the following step 1, step 2, and step 3:
(step 1) a step of ligand-exchanging the organic ligand of an organic ligand-containing quantum dot to a halogen element-containing substance to obtain a quantum dot solid containing the halogen element-containing substance as a ligand,
(step 2) a step of obtaining a dispersion by mixing the quantum dot solid obtained in step 1 with a solution or mixed solution containing one or more substances selected from a compound represented by the following general formula (1), a compound represented by the following general formula (2), and a precursor thereof,
(step 3) a step of obtaining a light absorption layer from the dispersion obtained in step 2:

   RMX₃ (1)

   wherein R is two or more of monovalent cations, M is a divalent metal cation, and X is a halogen anion,

   R¹R²R³ₙ₋₁MₙX₃ₙ₊₁ (2)

   wherein R¹, R², and R³ are each independently a monovalent cation, at least two of R¹, R², and R³ are different monovalent cations, and at least one of R¹, R², and R³ is a monovalent inorganic cation, M is a divalent metal cation, X is a halogen anion, and n is an integer of 1 or more and 10 or less.

### BRIEF DESCRIPTION OF THE DRAWINGS

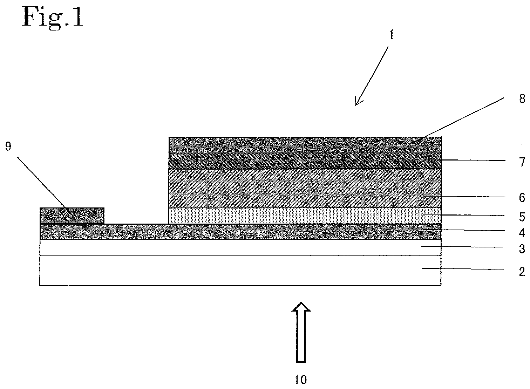

Fig. 1 is a schematic cross-sectional view showing an example of the structure of a photoelectric conversion element of the present invention.

### MODE FOR CARRYING OUT THE INVENTION

### <Light Absorption Layer>

The light absorption layer of the present invention comprises, as a light absorber, one or more perovskite compound selected from a compound represented by the following general formula (1) and a compound represented by the following general formula (2):

RMX₃ (1)

wherein R is two or more of monovalent cations, M is a divalent metal cation, and X is a halogen anion,

R¹R²R³ₙ₋₁MₙX₃ₙ₊₁ (2)

wherein R¹, R², and R³ are each independently a monovalent cation, at least two of R¹, R², and R³ are different monovalent cations, and at least one of R¹, R², and R³ is a monovalent inorganic cation, M is a divalent metal cation, X is a halogen anion, and n is an integer of 1 or more and 10 or less, and quantum dots dispersed in a matrix of the perovskite compound. In addition, the light absorption layer of the present invention may contain a light absorber other than the above in the range which does not impair the effect of the present invention.

The perovskite compound is preferably a compound represented by the general formula (1) from the viewpoint of achieving both improvement in durability and improvement in photoelectric conversion efficiency.

The R is two or more kinds of monovalent cations and examples thereof include an inorganic cation of a group 1 element of the periodic table and an organic cation. Examples of the inorganic cation of a group 1 element of the periodic table include Li⁺, Na⁺, K⁺, Rb⁺, and Cs⁺. From the viewpoint of improving the photoelectric conversion efficiency, one or more selected from K⁺, Rb⁺, and Cs⁺ is preferable, one or more selected from Rb⁺ and Cs⁺ is more preferable, and Cs⁺ is still more preferable. Examples of the organic cation include an ammonium ion which may have a substituent and a phosphonium ion which may have a substituent. There is no particular limitation on the substituent. Examples of the optionally substituted ammonium ion include an alkylammonium ion, a formamidinium ion and an arylammonium ion, and from the viewpoint of improvement in photoelectric conversion efficiency, the optionally substituted ammonium ion is preferably one or more kinds selected from an alkyl ammonium ion and a formamidinium ion, more preferably one or more kinds selected from a monoalkylammonium ion and a formamidinium ion, still more preferably one or more kinds selected from a methylammonium ion, an ethylammonium ion, a butylammonium ion and a formamidinium ion, and even still more preferably a methylammonium ion.

As a combination of two or more kinds of cations, any combination of an inorganic cation and an inorganic cation; an organic cation and an organic cation; or an inorganic cation and an organic cation may be used, though there is no particular limitation thereto. However, from the viewpoints of improvement in photoelectric conversion efficiency, improvement in durability, and cost reduction, a combination of an inorganic cation and an organic cation is preferable; a combination of one or more selected from K⁺, Rb⁺, and Cs⁺ and one or more selected from alkylammonium ion and formamidinium ion is more preferable; a combination of one or more selected from Rb⁺ and Cs⁺ and one or more selected from methylammonium ion, ethylammonium ion, butylammonium ion, and formamidinium ion is more preferable; and a combination of Cs⁺ and methylammonium ion is still more preferable.

The monovalent cation contained most in the R is not particularly limited, but an organic cation is preferable from the viewpoints of improvement in photoelectric conversion efficiency, improvement in durability, and cost reduction. On the other hand, the monovalent cation contained minimum in the R is preferably an inorganic cation. The molar ratio of the minimum contained monovalent cation to the total monovalent cations is preferably 0.01 or more, more preferably 0.05 or more, still more preferably 0.08 or more, even still more preferably 0.09 or more, and preferably 0.4 or less, more preferably 0.3 or less, still more preferably 0.2 or less, even still more preferably 0.15 or less, from the viewpoints of improvement in photoelectric conversion efficiency, improvement in durability, and cost reduction. From the same viewpoints, the molar ratio of the most contained monovalent cation to the total amount of monovalent cations is preferably 0.3 or more, more preferably 0.5 or more, still more preferably 0.8 or more. even still more preferably 0.85 or more, and preferably 0.99 or less, more preferably 0.95 or less, still more preferably 0.93 or less, even still more preferably 0.91 or less.

The R¹, the R², and the R³ are each independently a monovalent cation, at least two of R¹, R², and R³ are different monovalent cations, and at least one of R¹, R², and R³ is a monovalent inorganic cation. Examples of the monovalent cations include an inorganic cation of a group 1 element of the periodic table and an organic cation. Examples of the inorganic cation of a group 1 element of the periodic table include Li⁺, Na⁺, K⁺, Rb⁺, and Cs⁺. Among these, from the viewpoint of improving the photoelectric conversion efficiency, at least one selected from K⁺, Rb⁺, and Cs⁺ is preferable, one or more selected from Rb⁺ and Cs⁺ is more preferable, and Cs⁺ is still more preferable. Examples of the organic cation include an ammonium ion which may have a substituent and a phosphonium ion which may have a substituent. There is no particular restriction on the substituent. Examples of the optionally substituted ammonium ion include an alkylammonium ion, a formamidinium ion and an arylammonium ion, and from the viewpoint of improvement in photoelectric conversion efficiency, the optionally substituted ammonium ion is preferably one or more kinds selected from an alkyl ammonium ion and a formamidinium ion, more preferably one or more kinds selected from a monoalkylammonium ion and a formamidinium ion, still more preferably one or more kinds selected from a methylammonium ion, an ethylammonium ion, a butylammonium ion, a hexylammonium ion, an octylammonium ion, a decylammonium ion, a dodecyl ammonium ion, a tetradecyl ammonium ion, a hexadecyl ammonium ion, and an octadecyl ammonium ion, and still more preferably a methylammonium ion.

The combination of the R¹, the R² and the R³ may be any of an inorganic cation, an inorganic cation and an inorganic cation; an inorganic cation, an inorganic cation and an organic cation; or an inorganic cation, an organic cation and an organic cation, and there is no particular limitation thereto. However, from the viewpoint of improvement in photoelectric conversion efficiency, improvement in durability, and cost reduction, a combination of an inorganic cation, an inorganic cation and an organic cation, or a combination of an inorganic cation, an organic cation, and an organic cation is preferable, and a combination of an inorganic cation, an organic cation and an organic cation is more preferable.

The n is an integer of 1 to 10 and from the viewpoint of achieving both durability and photoelectric conversion efficiency, n is preferably 1 to 4.

The M is a divalent metal cation and includes, for example, Pb²⁺, Sₙ²⁺, Hg²⁺, Cd²⁺, Zn²⁺, Mn²⁺, Cu²⁺, Ni²⁺, Fe²⁺, Co²⁺, Pd²⁺, Ge²⁺, Y²⁺, and Eu²⁺. From the viewpoint of excellent durability (moisture resistance) and photoelectric conversion efficiency, the M is preferably Pb²⁺, Sn²⁺, or Ge²⁺, more preferably Pb²⁺ or Sn²⁺, still more preferably Pb²⁺.

The X is a halogen anion, and examples thereof include a fluorine anion, a chlorine anion, a bromine anion, and an iodine anion. From the viewpoint of improvement in photoelectric conversion efficiency, the X is preferably a chlorine anion, a bromine anion or an iodine anion, more preferably a bromine anion or an iodine anion, still more preferably an iodine anion.

Examples of the compound represented by the general formula (1) include Cs_{0.1}(CH₃NH₃)₀.₉PbCl₃, Cs₀.₁(CH₃NH₃)_{0.9}PbBr₃, Cs_{0.1}(CH₃NH₃)_{0.9}PbBrI₂, Cs_{0.1}(CH₃NH₃)_{0.9}PbBr₂I, Cs_{0.1}(CH₃NH₃)_{0.9}PbI₃, Cs_{0.1}(CH₃NH₃)₀.₉SnCl₃, Cs_{0.1}(CH₃NH₃)_{0.9}SnBr₃, and Cs_{0.1}(CH₃NH₃)_{0.9}SnI₃. Of these, from the viewpoints of improvement in photoelectric conversion efficiency, improvement in durability, and cost reduction, one or more selected from Cs_{0.1}(CH₃NH₃)_{0.9}PbBr₃ and Cs_{0.1}(CH₃NH₃)_{0.9}PbI₃ is preferable and Cs_{0.1}(CH₃NH₃)_{0.9}PbI₃ is more preferable.

Examples of the compound represented by the general formula (2) include Cs_{0.1}(C₁₂H₂₅NH₃)₁.₉PbI₄, Cs_{0.1}(C₁₂H₂₅NH₃)_{1.9}(CH₃NH₃)Pb₂I₇, Cs_{0.1}(C₁₂H₂₅NH₃)_{1.9}(CH₃NH₃)₂Pb₃I₁₀, Cs_{0.1}(C₁₂H₂₅NH₃)_{1.9}(CH₃NH₃)Pb₂Br₇, and Cs_{0.1}(C₁₂H₂₅NH₃)_{1.9}(CH₃NH₃)₂Pb₃Br₁₀. Of these, from the viewpoints of improvement in photoelectric conversion efficiency, improvement in durability, and cost reduction, one or more selected from Cs_{0.1}(C₁₂H₂₅NH₃)_{1.9}PbI₄, Cs_{0.1}(C₁₂H₂₅NH₃)₁.₉(CH₃NH₃)Pb₂I₇, and Cs_{0.1}(C₁₂H₂₅NH₃)₁.₉(CH₃NH₃)₂Pb₃I₁₀ are preferable, and one or more selected from Cs_{0.1}(C₁₂H₂₅NH₃)_{1.9}PbI₄ and Cs_{0.1}(C₁₂H₂₅NH₃)₁.₉(CH₃NH₃)Pb₂I₇ are more preferable.

From the viewpoint of improving the photoelectric conversion efficiency (voltage), the band gap energy of the perovskite compound is preferably 1.0 eV or more, more preferably 1.3 eV or more, still more preferably 1.5 eV or more, and from the viewpoint of improving the photoelectric conversion efficiency (current), the band gap energy of the perovskite compound is preferably 3.0 eV or less, more preferably 2.0 eV or less, still more preferably 1.7 eV or less. The band gap energies of the perovskite compound and the quantum dot can be determined from the absorption spectrum measured at 25°C by the method described in Examples described later. The wavelength corresponding to the band gap energy determined from the absorption spectrum is called an absorption edge wavelength.

The amount of perovskite raw material (metal halide salt) for the light absorption layer can be semi-quantified by powder X-ray diffraction (XRD) analysis. The ratio of the strongest peak intensity of the metal halide salt to the strongest peak intensity of the perovskite compound is preferably 0.01 or more, more preferably 0.05 or more, still more preferably 0.1 or more, and is preferably 1 or less, more preferably 0.7 or less, still more preferably 0.4 or less, from the viewpoint of improving the photoelectric conversion efficiency.

The crystallite diameter of the perovskite compound of the light absorption layer is preferably 10 nm or more, more preferably 20 nm or more, still more preferably 27 nm or more, from the viewpoint of improving the photoelectric conversion efficiency and is preferably 1000 nm or less from the same viewpoint. The crystallite diameter of the light absorption layer in the range of 100 nm or less can be measured by the method described in Examples below. Further, the crystallite diameter in the range exceeding 100 nm cannot be measured by the method described in Examples described later but does not exceed the thickness of the light absorption layer.

The perovskite compound can be produced, for example, from a perovskite compound precursor as described later. As a precursor of the perovskite compound, for example, in the case where the perovskite compound is a compound represented by the general formula (1), a combination of a compound represented by MX₂ and two or more kinds of compounds represented by RX can be mentioned. Also, in the case where the perovskite compound is a compound represented by the general formula (2), a combination of a compound represented by MX₂ with two or more kinds selected from a compound represented by R¹X, a compound represented by R²X, and a compound represented by R³X can be mentioned.

The perovskite compound in the light absorption layer can be identified by the conventional methods such as element analysis, infrared (IR) spectrum, Raman spectrum, nuclear magnetic resonance (NMR) spectrum, X-ray diffraction (XRD) pattern, absorption spectrum, emission spectrum, electron microscope observation, and electron beam diffraction.

The quantum dot is inorganic nanoparticle having a crystal structure with a particle diameter of about 20 nm or less and exhibit physical properties different from those of a bulk material due to the expression of the quantum size effect. Although known quantum dots can be used without particular limitation, it is preferred to use a quantum dot having a band gap energy of 0.2 eV or more and less than the band gap energy of the perovskite compound from the viewpoint of complementing the band gap energy which the perovskite compound does not have and improving the photoelectric conversion efficiency in the near infrared light region. The quantum dots may be used singly or in combination of two or more kinds having different band gap energies. When two or more kinds of perovskite compounds having different band gap energies are used, "the band gap energy less than the band gap energy of the perovskite compound", which is the upper limit of the band gap energy of the quantum dot, means a band gap energy less than the maximum value of the band gap energy of two or more kinds of perovskite compounds. Hereinafter, unless otherwise specified, preferred embodiments of quantum dots are preferred embodiments common to the light absorption layer and its raw materials.

From the viewpoint of improving the photoelectric conversion efficiency (voltage), the band gap energy of the quantum dot is preferably 0.8 eV or more, more preferably 0.9 eV or more, still more preferably 1.0 eV or more, and from the viewpoint of improving the photoelectric conversion efficiency (current), the band gap energy of the quantum dot is preferably 1.6 eV or less, more preferably 1.5 eV or less, still more preferably 1.4 eV or less, even still more preferably 1.3 eV or less.

Regarding the quantum dots, if the particle size and kind of quantum dots are determined by electron microscopic observation, electron beam diffraction, X-ray diffraction (XRD) pattern, etc., it is also possible to calculate the band gap energy from the correlation between the particle size and the band gap energy (see, for example, ACS Nano 2014, 8, 6363-6371).

The difference between the band gap energy of the perovskite compound and the band gap energy of the quantum dot is preferably 0.2 eV or more, more preferably 0.3 eV or more, still more preferably 0.4 eV or more, even still more preferably 0.5 eV or more, and preferably 2.0 eV or less, more preferably 1.5 eV or less, still more preferably 1.0 eV or less, even still more preferably 0.8 eV or less, even still more preferably 0.7 eV or less, from the viewpoint of improving photoelectric conversion efficiency.

The particle diameter of the quantum dot is not particularly limited, but from the viewpoints of expressing quantum effect, improving dispersibility, structural stability, and photoelectric conversion efficiency, the particle diameter is preferably 1 nm or more, more preferably 2 nm or more, still more preferably 3 nm or more, and preferably 20 nm or less, more preferably 10 nm or less, still more preferably 5 nm or less. The particle size of the quantum dot can be measured by a conventional method such as crystallite diameter analysis of XRD (X-ray diffraction) or transmission electron microscope observation.

Examples of the quantum dots having such a band gap energy include metal oxides, metal chalcogenides (such as sulfides, selenides, and tellurides), specifically PbS, PbSe, PbTe, CdS, CdSe, CdTe, Sb₂S₃, Bi₂S₃, Ag₂S, Ag₂Se, Ag₂Te, Au₂S, Au₂Se, Au₂Te, Cu₂S, Cu₂Se, Cu₂Te, Fe₂S, Fe₂Se, Fe₂Te, In₂S₃, SnS, SnSe, SnTe, CuInS₂, CuInSe₂, CuInTe₂, EuS, EuSe, and EuTe. From the viewpoint of excellent durability (oxidation resistance) and photoelectric conversion efficiency, the quantum dot preferably contains Pb element, more preferably PbS or PbSe, still more preferably PbS.

From the viewpoints of dispersibility in the light absorption layer and the dispersion, ease of production, cost, and expression of excellent performance, the quantum dot mentioned above may include preferably a quantum dot containing a halogen element-containing substance as a ligand, or a quantum dot containing an organic compound and a halogen element-containing substance as ligands.

Examples of the organic compound as a ligand (hereinafter also referred to as an organic ligand) include a carboxy group-containing compound, an amino group-containing compound, a thiol group-containing compound, and a phosphino group-containing compound.

Examples of the carboxyl group-containing compound include oleic acid, stearic acid, palmitic acid, myristic acid, lauric acid, capric acid, and the like.

Examples of the amino group-containing compound include oleylamine, stearylamine, palmitylamine, myristylamine, laurylamine, caprylamine, octylamine, hexylamine, butylamine and the like.

Examples of the thiol group-containing compound include ethanethiol, ethanedithiol, benzenethiol, benzenedithiol, decanethiol, decanedithiol, mercaptopropionic acid, and the like.

Examples of the phosphino group-containing compound include trioctylphosphine, tributylphosphine, and the like.

The organic ligand is preferably a carboxy group-containing compound or an amino group-containing compound, more preferably a carboxy group-containing compound, still more preferably fatty acid having 8 or more carbon atoms, even still more preferably fatty acid having 12 or more carbon atoms, even still more preferably oleic acid, from the viewpoints of ease of production, dispersion stability, versatility, cost, and excellent performance expression of the quantum dot.

In the case where the quantum dot contains an organic ligand, the molar ratio of the organic ligand to the metal element constituting the quantum dot is preferably 0.001 or more, more preferably 0.005 or more, still more preferably 0.01 or more, and preferably 0.6 or less, more preferably 0.1 or less, still more preferably 0.05 or less, from the viewpoint of improving the dispersibility of quantum dots in the light absorption layer or in the dispersion to exhibit excellent performance.

The halogen element of the halogen element-containing substance as the ligand is not particularly limited, and examples thereof include fluorine, chlorine, bromine, and iodine. The halogen element is preferably iodine or bromine, more preferably iodine, from the viewpoints of ease of production, dispersion stability, versatility, cost, expression of excellent performance of quantum dots, and the like.

Examples of the halogen element-containing substance as the ligand include iodine, ammonium iodide, and methylammonium iodide, and iodine is preferable from the viewpoints of ease of production, dispersion stability, versatility, cost, expression of excellent performance of quantum dots, and the like.

The atomic ratio of the halogen element to the metal element constituting the quantum dot is not particularly limited, but from the viewpoint of improving the dispersibility of quantum dots in the light absorption layer or in the dispersion, as well as from the viewpoint of suppressing the carrier transfer from the perovskite compound to the quantum dot, such atomic ratio is preferably 0.1 or more, more preferably 0.2 or more, still more preferably 0.3 or more, and preferably 1 or less, more preferably 0.8 or less, still more preferably 0.7 or less.

The quantum dots of the light absorption layer can be identified, for example, by element analysis, infrared (IR) spectrum, Raman spectrum, nuclear magnetic resonance (NMR) spectrum, X-ray diffraction (XRD) pattern, absorption spectrum, emission spectrum, small angle X-ray scattering, electron microscopic observation, electron beam diffraction, and the like.

A preferable combination of the perovskite compound and the quantum dot is preferably a combination of compounds containing the same metal element from the viewpoint of the uniform dispersibility of quantum dots, durability, and photoelectric conversion efficiency, for example, a combination of Cs_{0.1}(CH₃NH₃)_{0.9}PbBr₃ and PbS, a combination of Cs_{0.1}(CH₃NH₃)_{0.9}PbI₃ and PbS, a combination of Cs_{0.1}(CH₃NH₃)_{0.9}PbBr₃ and PbSe, and a combination of Cs_{0.1}(CH₃NH₃)_{0.9}PbI₃ and PbSe, and more preferably a combination of Cs_{0.1}(CH₃NH₃)_{0.9}PbI₃ and PbS.

The light absorption layer of the present invention preferably has an intermediate-band. The intermediate-band is an energy level formed by the interaction between quantum dots in the band gap of the perovskite compound and exists at an energy position near the lower end of the conduction band of the quantum dot and/or near the upper end of the valence band of the quantum dot. The intermediate-band is formed, for example, by regularly arranging the quantum dots at high density in a matrix of the perovskite compound. When an intermediate-band is present within the band gap of the perovskite compound, for example, two-step light absorption occurs in such a manner that electrons photoexcited from a valence band of the perovskite compound to the intermediate-band further photoexcite from the intermediate-band to a conduction band of the perovskite compound. Therefore, the presence of the intermediate-band can be confirmed by measuring a quantum efficiency of the two-step light absorption, that is, an external quantum efficiency difference (ΔEQE) described in Examples.

The content ratio of the quantum dot to the total content of the perovskite compound and the quantum dot in the light absorption layer is preferably 7.5% by mass or more, more preferably 10% by mass or more, still more preferably 15% by mass or more, even still more preferably 17% by mass or more, from the viewpoint of improving the quantum efficiency of two-step light absorption by forming an intermediate-band in the light absorption layer by way of making the distance between the quantum dots small due to the interaction between the quantum dots, and is preferably 40% by mass or less, more preferably 30% by mass or less, still more preferably 25% by mass or less, from the viewpoints of film formability as well as suppression of carrier transfer from the perovskite compound to the quantum dot so that photoelectric conversion efficiency is improved.

The distance between the quantum dot particles in the light absorption layer is preferably 10 nm or less, more preferably 6 nm or less, still more preferably 4.5 nm or less, from the viewpoint of improving the quantum efficiency of two-step light absorption by forming an intermediate-band in the light absorption layer by way of making the distance between the quantum dots small due to the interaction between the quantum dots, thereby to enhance the photoelectric conversion efficiency.

The particle density of the quantum dots in the light absorption layer is preferably 1 × 10¹⁰/cm² or more, more preferably 1 × 10¹¹/cm² or more, still more preferably 1 × 10¹²/cm² or more, even still more preferably 2.2 × 10¹²/cm² or more, from the viewpoint of forming an intermediate-band in the light absorption layer by the interaction between quantum dots and improving a quantum efficiency of the two-step light absorption to improve photoelectric conversion efficiency. From the viewpoint of improving film formation and photoelectric conversion efficiency by suppressing carrier transfer from perovskite compounds to quantum dots, the particle density of the quantum dots is preferably 1 × 10¹⁴/cm² or less, more preferably 1 × 10¹³/cm² or less, and still more preferably 5 × 10¹²/cm² or less.

In the present invention, the external quantum efficiency difference (ΔEQE) at 700 nm of the light absorption layer is inferred as corresponding to a quantum efficiency of two-step light absorption in such a manner that electrons photoexcited from the valence band to the conduction band of the perovskite compound move to the intermediate-band and then from the intermediate-band to the conduction band of the perovskite compound. The external quantum efficiency difference (ΔEQE) at 700 nm of the light absorption layer is preferably 0.1% or more, more preferably 0.5% or more, still more preferably 1% or more, from the viewpoint of improving photoelectric conversion efficiency.

In the present invention, the external quantum efficiency difference (ΔEQE) at 900 nm of the light absorption layer is inferred as corresponding to a quantum efficiency of two-step light absorption in such a manner that electrons photoexcited from the valence band of the perovskite compound to the intermediate-band are further photoexcited to the conduction band of the perovskite compound. The external quantum efficiency difference (ΔEQE) at 900 nm of the light absorption layer is preferably 0.01% or more, more preferably 0.03% or more, still more preferably 0.05% or more, from the viewpoint of improving photoelectric conversion efficiency.

In the present invention, the external quantum efficiency difference (ΔEQE) at 1100 nm of the light absorption layer is inferred as corresponding to a quantum efficiency of two-step light absorption in such a manner that electrons photoexcited from the valence band of the quantum dots to the intermediate-band are further photoexcited to the conduction band of the perovskite compound. The external quantum efficiency difference (ΔEQE) at 1100 nm of the light absorption layer is preferably 0.005% or more, more preferably 0.01% or more, still more preferably 0.02% or more, from the viewpoint of improving photoelectric conversion efficiency.

The energy difference between the valence band of the perovskite compound and the intermediate-band is preferably 1.0 eV or more, more preferably 1.2 eV or more, still more preferably 1.3 eV or more, and is preferably 2.0 eV or less, more preferably 1.6 eV or less, still more preferably 1.4 eV or less, from the viewpoint of improving photoelectric conversion efficiency.

Further, the energy difference between the intermediate-band and the conduction band of the perovskite compound is preferably 0.1 eV or more, more preferably 0.2 eV or more, still more preferably 0.3 eV or more, and is preferably 1.5 eV or less, more preferably 0.8 eV or less, still more preferably 0.6 eV or less, from the viewpoint of improving photoelectric conversion efficiency.

In the present invention, the external quantum efficiency (EQE) at 500 nm of the light absorption layer is derived from the light absorption of the perovskite compound. The EQE of the light absorption layer at 500 nm is preferably 10% or more, more preferably 30% or more, still more preferably 40% or more, from the viewpoint of improving photoelectric conversion efficiency.

In the present invention, the external quantum efficiency (EQE) at 500 nm of the light absorption layer may be lower than that of the perovskite compound alone containing no quantum dots. In that case, since the energy levels of the valence band upper end and the conduction band lower end of the quantum dot exist in the band gap of the perovskite compound, it is speculated that carriers (electrons, holes) generated by the light absorption of the perovskite compound move to the quantum dots, so that the EQE at 500 nm decreases. From the viewpoint of improving photoelectric conversion efficiency, the EQE ratio of the light absorption layer of the present invention to the EQE of the light absorption layer of the perovskite compound alone at 500 nm is preferably 0.1 or more, more preferably 0.3 or more, and still more preferably 0.55 or more.

In the present invention, the external quantum efficiency (EQE) at 900 nm of the light absorption layer is derived from the light absorption of the quantum dots. The EQE of the light absorption layer at 900 nm is preferably 0.1% or more, more preferably 1% or more, still more preferably 1.5% or more, from the viewpoint of improving photoelectric conversion efficiency.

The thickness of the light absorption layer is not particularly limited, but is preferably 30 nm or more, more preferably 50 nm or more, still more preferably 80 nm or more, from the viewpoint of increasing light absorption to improve photoelectric conversion efficiency, and preferably 1000 nm or less, more preferably 800 nm or less, still more preferably 600 nm or less, even still more preferably 500 nm or less, from the viewpoint of improving photoelectric conversion efficiency by improving carrier transfer efficiency to a hole transport material layer and an electron transport material layer. The thickness of the light absorption layer can be measured by a measuring method such as electron microscope observation of the cross section of the film.

From the viewpoint of improving the strength of a hole transport material (HTM) layer, the surface smoothness of the light absorption layer is preferably 100 nm or more, more preferably 200 nm or more, still more preferably 300 nm or more, even still more preferably 400 nm or more, and from the viewpoint of improving the photoelectric conversion efficiency, the surface smoothness of the light absorption layer is preferably 1000 nm or less, more preferably 800 nm or less, still more preferably 700 nm or less.

The coverage of the light absorption layer to the porous layer is preferably 10% or more, more preferably 20% or more, still more preferably 30% or more, even still more preferably 40% or more, furthermore preferably 50% or more, from the viewpoint of improving the photoelectric conversion efficiency (current), and is 100% or less.

From the viewpoint of improving the photoelectric conversion efficiency (voltage), the absorbance ratio (QD/P) of the quantum dot (QD) to the perovskite compound (P) in the light absorption layer is preferably 0.3 or less, more preferably 0.2 or less, still more preferably 0.1 or less, even still more preferably 0. The absorbance ratio (QD/P) in the light absorption layer is determined from the absorption spectrum of the light absorption layer measured by the method described in the following Example and is the ratio of the maximum absorbance of at least one kind of quantum dots to the absorbance of at least one kind of perovskite compounds. Here, the absorbance of at least one kind of quantum dots and the absorbance of at least one kind of perovskite compounds are obtained respectively as the absorbance at the absorption peak position when they are measured independently.

When the light absorption layer is excited with light that is the band gap energy or more of the quantum dots and less than the band gap energy of the perovskite, the emission peak energy in the light absorption layer is preferably 0.2 eV or more, more preferably 0.4 eV or more, still more preferably 0.6 eV or more, even still more preferably 0.8 eV or more, from the viewpoint of improving photoelectric conversion efficiency (voltage), and the emission peak energy in the light absorption layer is preferably 1.4 eV or less, more preferably 1.3 eV or less, still more preferably 1.2 eV or less, even still more preferably 1.1 eV or less, from the viewpoint of improving photoelectric conversion efficiency (current).

From the viewpoint of improving photoelectric conversion efficiency, the difference between the light emission peak energy in the light absorption layer and the band gap energy of the perovskite compound is preferably 0.2 eV or more, more preferably 0.4 eV or more, still more preferably 0.5 eV or more, and preferably 1.5 eV or less, more preferably 1.0 eV or less, still more preferably 0.7 eV or less.

From the viewpoint of improving photoelectric conversion efficiency, the difference between the light emission peak energy in the light absorption layer and the band gap energy of the quantum dot is preferably 1.0 eV or less, more preferably 0.5 eV or less, still more preferably 0.3 eV or less, even still more preferably 0 eV.

### <Method for manufacturing light absorption layer>

The method for manufacturing the light absorption layer is not particularly limited. For example, a so-called wet process in which a dispersion containing the perovskite compound and/or a precursor thereof and the quantum dot is coated on a substrate and then dried is preferably mentioned. From the viewpoints of ease of production, cost, storage stability of the dispersion, improvement of photoelectric conversion efficiency, etc., a manufacturing method including the following step 1, step 2, and step 3 is preferable.
(step 1) a step of ligand-exchanging the organic ligand of an organic ligand-containing quantum dot to a halogen element-containing substance to obtain a quantum dot solid containing the halogen element-containing substance as a ligand,
(step 2) a step of obtaining a dispersion by mixing the quantum dot solid obtained in step 1 with a solution or mixed solution containing one or more substances selected from a compound represented by the general formula (1), a compound represented by the general formula (2), and a precursor thereof,
(step 3) a step of obtaining a light absorption layer from the dispersion obtained in step 2.

The step (step 1) of ligand-exchanging the organic ligand of an organic ligand-containing quantum dot to a halogen element-containing substance to obtain a quantum dot solid containing the halogen element-containing substance as a ligand is preferable from the viewpoints of improving the dispersibility of the dispersion containing the perovskite compound and/or its precursor and the quantum dots and improving the photoelectric conversion efficiency by improving the carrier transfer speed in the light absorption layer.

In general, there is a case where quantum dots are synthesized by using, as a ligand, a hydrophobic organic compound having a relatively large molecular size, such as oleic acid, for controlling the particle diameter of the quantum dots, inhibiting aggregation, improving the dispersibility, and the like. In this case, the quantum dots exhibit excellent dispersibility in a non (or low)-polar organic solvent such as toluene, but the dispersibility in a polar organic solvent such as N,N-dimethylformamide and methanol is poor. Accordingly, when the solvent for dispersing or dissolving the perovskite compound and/or its precursor is a polar organic solvent, it is necessary to disperse the quantum dots in the polar organic solvent, and it is preferable to coordinate a substance having high compatibility with the polar organic solvent to the quantum dot. In addition, organic compounds which are relatively large in molecular size and are hydrophobic, such as oleic acid, are low in conductivity and hinder diffusion of carriers in the light absorption layer. Therefore, from the viewpoint of improving the carrier transfer speed in the light absorption layer to improve the photoelectric conversion efficiency, it is preferable to coordinate a substance having a relatively small molecular size to a quantum dot. From the above viewpoint, the ligand of the quantum dot includes preferably one or more halogen element-containing substances selected from iodine, ammonium iodide, methylammonium iodide, bromine, ammonium bromide and methylammonium bromide and the like, more preferably iodine or bromine, still more preferably iodine.

As a method for ligand exchange of an organic ligand of the quantum dot containing the organic ligand to a halogen element-containing substance, there is mentioned preferably a method of exchanging a ligand in a dispersion and more preferably a method in which a dispersion of the quantum dot containing the organic ligand and a raw material solution of a halogen element-containing substance are mixed over time at room temperature (25°C) without stirring and allowed to stand to perform ligand exchange, from the viewpoints of ease of production, cost, storage stability of the dispersion, and improvement of photoelectric conversion efficiency.

As the halogen element-containing substance raw material used for the ligand exchange, it includes preferably methylammonium iodide (methylamine hydroiodide), ammonium iodide, iodine, methylammonium bromide (methylamine hydrobromide), ammonium bromide, bromine and the like. However, from the viewpoints of ease of production, cost, storage stability of the dispersion, and improvement of photoelectric conversion efficiency, one or more members selected from methylammonium iodide (methylamine hydroiodide), ammonium iodide, methylammonium bromide (methylamine hydrobromide), and ammonium bromide are preferred; one or more members selected from methylammonium iodide (methylamine hydroiodide) and methylammonium bromide (methylamine hydrobromide) are more preferred; and methylammonium iodide (methylamine hydroiodide) is still more preferred.

From the viewpoints of ease of production, cost, storage stability of the dispersion, improvement of photoelectric conversion efficiency and the like, the mixing amount of the halogen element-containing substance raw material used for ligand exchange is preferably such that the molar ratio of the halogen element to the organic compound on the quantum dot surface is preferably 0.1 or more, more preferably 1 or more, still more preferably 1.5 or more, and preferably 10 or less, more preferably 8 or less, still more preferably 5 or less.

From the viewpoints of ease of production, storage stability of the dispersion, improvement of photoelectric conversion efficiency and the like, the solvent used for ligand exchange is preferably a mixed solvent of a solvent capable of dispersing quantum dots well and a solvent capable of dissolving a halogen element-containing substance raw material. The solvent for dispersing the quantum dots is preferably one or more non-(low)polar organic solvents selected from toluene, hexane, octane and the like, and is more preferably toluene. The solvent for dissolving the halogen element-containing substance raw material is preferably at least one aprotic polar organic solvent selected from N,N-dimethylformamide, dimethyl sulfoxide, γ-butyrolactone and the like, more preferably N,N-dimethylformamide.

The solid content concentration of the quantum dot in the quantum dot dispersion to be mixed at the time of ligand exchange is preferably 10 mg/mL or more, more preferably 50 mg/mL or more, still more preferably 80 mg/mL or more, and preferably 1000 mg/mL or less, more preferably 500 mg/mL or less, still more preferably 200 mg/mL or less, from the viewpoints of ease of production, cost, storage stability of the dispersion, improvement of photoelectric conversion efficiency and the like.

The concentration of the halogen element-containing substance raw material in the halogen element-containing substance raw material solution to be mixed at the time of ligand exchange is preferably 0.01 mol/L or more, more preferably 0.1 mol/L or more, still more preferably 0.2 mol/L or more, and preferably 1 mol/L or less, more preferably 0.5 mol/L or less, still more preferably 0.3 mol/L or less, from the viewpoints of ease of production, cost, storage stability of the dispersion, improvement of photoelectric conversion efficiency and the like.

The method of mixing the quantum dot dispersion and the halogen element-containing substance raw material solution at the time of ligand exchange is not particularly limited as long as it is a method of mixing without stirring over a long period of time. However, from the viewpoints of ease of production, cost, storage stability of the dispersion, improvement of photoelectric conversion efficiency and the like, preferred is a continuous method or a dropping method (semi-continuous method) and more preferred is a dropping method.

As the continuous method, a method of mixing a raw material solution of a halogen element-containing substance in a quantum dot dispersion or a method of mixing a quantum dot dispersion in a raw material solution of a halogen element-containing substance may be used. However, from the viewpoints of ease of production, cost, storage stability of the dispersion, improvement of photoelectric conversion efficiency and the like, a method of mixing a raw material solution of a halogen element-containing substance in a quantum dot dispersion is preferable. The mixing speed is preferably 25 µl/sec or less, more preferably 5 µl/sec or less, still more preferably 3 µl/sec or less, and preferably 0.2 µl/sec or more, more preferably 0.4 µl/sec or more, still more preferably 1.5 µl/sec or more, from the viewpoint of ease of production, cost, storage stability of the dispersion, improvement of photoelectric conversion efficiency and the like.

As the dropping method, a method of dropping a raw material solution of a halogen element-containing substance to a quantum dot dispersion or a method of dropping a quantum dot dispersion to a raw material solution of a halogen element-containing substance may be used. However, from the viewpoints of ease of production, cost, storage stability of the dispersion, improvement of photoelectric conversion efficiency and the like, a method of dropping a raw material solution of a halogen element-containing substance to a quantum dot dispersion is preferable. The dropping rate is preferably 1 drop/1 second or less, more preferably 1 drop/5 seconds or less, still more preferably 1 drop/8 seconds or less, and preferably 1 drop/100 seconds or more, more preferably 1 drop/50 seconds or more, still more preferably 1 drop/15 seconds or more, from the viewpoints of ease of production, cost, storage stability of the dispersion, improvement of photoelectric conversion efficiency and the like.

From the viewpoints of ease of production, cost, storage stability of the dispersion, improvement of photoelectric conversion efficiency and the like, the time allowed to stand still the mixture after mixing the quantum dot dispersion and the halogen element-containing substance raw material solution is preferably 0.1 hours or more, more preferably 1 hour or more, still more preferably 10 hours or more, and preferably 100 hours or less, more preferably 48 hours or less, still more preferably 24 hours or less.

As a method for obtaining a quantum dot solid having an organic compound and a halogen element-containing substance as the ligands after ligand exchange, there is a preferable method comprising adding a washing solvent to a mixture dispersion of a quantum dot dispersion and a halogen element-containing substance raw material solution and filtering the resulting mixture to remove the organic compound coordinated on the surface of the quantum dot, the excess halogen element-containing substance raw material and the solvent. The washing solvent is preferably an organic solvent in which any quantum dots before and after ligand exchange are hardly dispersed and an organic compound and a halogen element-containing substance are soluble, and from the viewpoints of ease of production, cost, storage stability of the dispersion, improvement of photoelectric conversion efficiency and the like, an alcohol solvent is more preferable, and methanol is still more preferable. The amount of the washing solvent is preferably 0.1 or more, more preferably 0.5 or more, still more preferably 1 or more, and preferably 10 or less, more preferably 5 or less, still more preferably 2 or less, as the volume ratio of the washing solvent to the amount of the mixed dispersion of the quantum dot dispersion and the halogen element-containing substance raw material solution. From the viewpoints of ease of production, cost, storage stability of the dispersion, improvement of photoelectric conversion efficiency and the like, the filter pore size at the time of filtration is preferably 0.1 µm or more, more preferably 0.2 µm or more, and preferably 1 µm or less, more preferably 0.5 µm or less. The filter material is preferably a hydrophobic material, more preferably polytetrafluoroethylene (PTFE).

It is preferable to obtain a dispersion containing a quantum dot and one or more members selected from a perovskite compound and its precursor, via the step (step 2) of mixing the quantum dot solid obtained in step 1 and a solution or mixed solution containing one or more substances selected from a compound represented by the general formula (1), a compound represented by the general formula (2), and a precursor thereof.

The dispersion containing the perovskite compound and/or its precursor and the quantum dots preferably contains a solvent in view of film-forming property, cost, storage stability, and excellent performance (for example, photoelectric conversion characteristics). Examples of the solvent include esters (methyl formate, ethyl formate, etc.), ketones (γ-butyrolactone, N-methyl-2-pyrrolidone, acetone, dimethyl ketone, diisobutyl ketone, etc.), ethers (diethyl ether, methyl tert-butyl ether, dimethoxymethane, 1,4-dioxane, tetrahydrofuran, etc.), alcohols (methanol, ethanol, 2-propanol, tert-butanol, methoxypropanol, diacetone alcohol, cyclohexanol, 2-fluoroethanol, 2,2,2-trifluoroethanol, 2,2,3,3-tetrafluoro-1-propanol, etc.), glycol ethers (cellosolves), amide type solvents (N,N-dimethylformamide, acetamide, N,N-dimethylacetamide, etc.), nitrile type solvents (acetonitrile, isobutyronitrile, propionitrile, methoxyacetonitrile etc.), carbonate type solvents (ethylene carbonate, propylene carbonate, etc.), halogenated hydrocarbons (methylene chloride, dichloromethane, chloroform, etc.), hydrocarbons, dimethylsulfoxide, and the like.

The solvent of the dispersion is preferably a polar solvent, more preferably at least one solvent selected from ketones, amide type solvents, and dimethylsulfoxide (DMSO), still more preferably amide type solvents, even still more preferably N,N-dimethylformamide, from the viewpoints of film forming properties, cost, storage stability, and expression of excellent performance (for example, photoelectric conversion characteristics).

From the viewpoints of film-forming property, cost, storage stability, and expression of excellent performance (for example, photoelectric conversion characteristics), the metal concentration of the perovskite compound and/or its precursor in the dispersion is preferably 0.1 mol/L or more, more preferably 0.2 mol/L or more, still more preferably 0.3 mol/L or more, and preferably 1.5 mol/L or less, more preferably 1.0 mol/L or less, still more preferably 0.5 mol/L or less.

From the viewpoints of film-forming property, cost, storage stability, and expression of excellent performance (for example, photoelectric conversion characteristics), the solid content concentration of the quantum dots in the dispersion is preferably 1 mg/mL or more, more preferably 10 mg/mL or more, still more preferably 50 mg/mL or more, and preferably 100 mg/mL or less, more preferably 80 mg/mL or less, still more preferably 60 mg/mL or less.

The method of preparing the dispersion is not particularly limited, but from the viewpoints of ease of production, cost, storage stability of the dispersion, improvement of photoelectric conversion efficiency and the like, the mixing temperature is preferably 0°C or more, more preferably 10°C or more, still more preferably 20°C or more, and preferably 50°C or less, more preferably 40°C or less, still more preferably 30°C or less. In addition, from the same viewpoint, the mixing time is preferably more than 0 hour, more preferably 0.1 hours or more, and preferably 72 hours or less, more preferably 24 hours or less, still more preferably 1 hour or less.

The dispersion which has been filtered to remove coarse particles is preferable, and from the viewpoints of ease of production, cost, storage stability of the dispersion, improvement of photoelectric conversion efficiency and the like, the filter pore diameter at the time of filtration is preferably 0.1 µm or more, more preferably 0.2 µm or more, and preferably 1 µm or less, more preferably 0.5 µm or less. The filter material is preferably a hydrophobic material, more preferably polytetrafluoroethylene (PTFE).

The step (step 3) of obtaining a light absorption layer from the dispersion obtained in step 2 is preferably a wet process such as applying (coating) the dispersion obtained in step 2 onto a substrate, said wet process including a gravure coating method, a bar coating method, a printing method, a spraying method, a spin coating method, a dipping method, a die coating method, etc. From the viewpoints of ease of production, cost, and expression of excellent performance (for example, photoelectric conversion characteristics), a spin coating method is preferable. The maximum rotation speed of the spin coating method is preferably 500 rpm or more, more preferably 1000 rpm or more, still more preferably 2000 rpm or more, and preferably 6000 rpm or less, more preferably 5000 rpm or less, still more preferably 4000 rpm or less, from the viewpoint of expression of excellent performance (for example, photoelectric conversion characteristics). In addition, from the viewpoints of ease of production, cost, improvement of photoelectric conversion characteristics and the like, a method of dropping a poor solvent during spin coating to improve the rate of crystal precipitation of the perovskite compound is preferable, and toluene or chlorobenzene is preferable as the poor solvent.

As a drying method in the wet process, for example, a thermal drying, an air stream drying, a vacuum drying and the like can be mentioned, from the viewpoints of ease of production, cost, and expression of excellent performance (for example, photoelectric conversion characteristics), and the thermal drying is preferable. The temperature of the thermal drying is preferably 60°C or more, more preferably 80°C or more, still more preferably 100°C or more, from the viewpoint of expression of excellent performance (e.g. photoelectric conversion characteristics), and preferably 200°C or less, more preferably 150°C or less, still more preferably 120°C or less, from the same viewpoint and in view of cost. The time for thermal drying is preferably 1 minute or more, more preferably 5 minutes or more, still more preferably 10 minutes or more, from the viewpoint of expression of excellent performance (for example, photoelectric conversion characteristics), and preferably 120 minutes or less, more preferably 60 minutes or less, still more preferably 30 minutes or less, from the same viewpoint and in view of cost.

### <Photoelectric Conversion Element>

The photoelectric conversion element of the present invention has the light absorption layer. In the photoelectric conversion element of the present invention, the configuration other than the light absorption layer is not particularly limited, and a configuration of a known photoelectric conversion element can be applied. In addition, the photoelectric conversion element of the present invention can be manufactured by a known method, except for the light absorption layer.

Hereinafter, the structure and manufacturing method of the photoelectric conversion element of the present invention will be described with reference to Fig. 1, but Fig. 1 is merely an example, and the present invention is not limited to the embodiment shown in Fig. 1.

Fig. 1 is a schematic sectional view showing an example of a structure of a photoelectric conversion element of the present invention. A photoelectric conversion element 1 has a structure in which a transparent substrate 2, a transparent conductive layer 3, a blocking layer 4, a porous layer 5, a light absorption layer 6, and a hole transport layer 7 are sequentially laminated. A transparent electrode substrate on the incident side of light 10 is composed of the transparent substrate 2 and the transparent conductive layer 3, and the transparent conductive layer 3 is bonded to an electrode (negative electrode) 9 which is a terminal for electrically connecting to an external circuit. In addition, the hole transport layer 7 is bonded to an electrode (positive electrode) 8 which serves as a terminal for electrically connecting to an external circuit.

As the material of the transparent substrate 2, any material may be used as long as it has strength, durability and light permeability, and synthetic resin and glass can be used for such a purpose. Examples of the synthetic resin include thermoplastic resins such as polyethylene naphthalate (PEN) film, polyethylene terephthalate (PET), polyester, polycarbonate, polyolefin, polyimide, and fluorine resin. From the viewpoints of strength, durability, cost and the like, it is preferable to use a glass substrate.

As the material of the transparent conductive layer 3, for example, indium-added tin oxide (ITO), fluorine-added tin oxide (FTO), tin oxide (SnO₂), indium zinc oxide (IZO), zinc oxide (ZnO), a polymer material having high conductivity and the like can be mentioned. Examples of the polymer material include polyacetylene type polymer materials, polypyrrole type polymer materials, polythiophene type polymer materials, and polyphenylenevinylene type polymer materials. As the material of the transparent conductive layer 3, a carbon-based thin film having high conductivity can also be used. Examples of a method for forming the transparent conductive layer 3 include a sputtering method, a vapor deposition method, a method of coating a dispersion, and the like.

Examples of the material of the blocking layer 4 include titanium oxide, aluminum oxide, silicon oxide, niobium oxide, tungsten oxide, tin oxide, zinc oxide, and the like. Examples of a method for forming the blocking layer 4 include a method of directly sputtering the above material on the transparent conductive layer 3 and a spray pyrolysis method. In addition, there is a method wherein a solution in which the above material is dissolved in a solvent or a solution in which a metal hydroxide that is a precursor of a metal oxide is dissolved is coated on the transparent conductive layer 3, dried, and baked as necessary. Examples of the coating method include gravure coating, bar coating, printing, spraying, spin coating, dipping, die coating, and the like.

The porous layer 5 is a layer having a function of supporting the light absorption layer 6 on its surface. In order to increase the light absorption efficiency in the solar cell, it is preferable to increase the surface area of the portion receiving light. By providing the porous layer 5, it is possible to increase the surface area of such a light-receiving portion.

Examples of the material of the porous layer 5 include a metal oxide, a metal chalcogenide (for example, a sulfide and a selenide), a compound having a perovskite type crystal structure (excluding the light absorber described above), a silicon oxide (for example, silicon dioxide and zeolite), and carbon nanotubes (including carbon nanowires and carbon nanorods), and the like.

Examples of the metal oxide include oxides of titanium, tin, zinc, tungsten, zirconium, hafnium, strontium, indium, cerium, yttrium, lanthanum, vanadium, niobium, aluminum, tantalum, and the like, and examples of the metal chalcogenide include zinc sulfide, zinc selenide, cadmium sulfide, cadmium selenide, and the like.

Examples of the compound having a perovskite type crystal structure include strontium titanate, calcium titanate, barium titanate, lead titanate, barium zirconate, barium stannate, lead zirconate, strontium zirconate, strontium tantalate, potassium niobate, bismuth ferrate, barium strontium titanate, barium lanthanum titanate, calcium titanate, sodium titanate, bismuth titanate, and the like.

The material for forming the porous layer 5 is preferably used as fine particles, more preferably as a dispersion containing fine particles. Examples of a method for forming the porous layer 5 include a wet method, a dry method, and other methods (for example, methods described in Chemical Review, Vol. 110, page 6595 (2010)). In these methods, it is preferable to coating the surface of the blocking layer 4 with a dispersion (paste), followed by baking. By baking, the fine particles can be brought into close contact with each other. Examples of coating methods include gravure coating method, bar coating method, printing method, spraying method, spin coating method, dipping method, die coating method, and the like.

The light absorption layer 6 is the above-described Light absorption layer of the present invention. A method of forming the light absorption layer 6 is not particularly limited, and, for example, there is preferably mentioned a method based on a so-called wet process in which a dispersion containing the perovskite compound and/or its precursor and the quantum dots is prepared and the prepared dispersion is coated on the surface of the porous layer 5, and is dried. From the viewpoints of ease of production, cost, storage stability of the dispersion, improvement of photoelectric conversion efficiency and the like, a manufacturing method including step 1, step 2 and step 3 is preferable as a method of forming the light absorption layer 6.

As a material of the hole transport layer 7, there can be mentioned, for example, a carbazole derivative, a polyarylalkane derivative, a phenylenediamine derivative, an arylamine derivative, an amino-substituted chalcone derivative, a styrylanthracene derivative, a fluorene derivative, a hydrazone derivative, a stilbene derivative, a silazane derivative, an aromatic tertiary amine compound, a styrylamine compound, an aromatic dimethylidine-based compound, a porphyrin-based compound, a phthalocyanine-based compound, a polythiophene derivative, a polypyrrole derivative, a polyparaphenylene vinylene derivative, and the like. Examples of a method for forming the hole transport layer 7 include a coating method, a vacuum vapor deposition method and the like. Examples of the coating method include a gravure coating method, a bar coating method, a printing method, a spray method, a spin coating method, a dipping method, a die coating method, and the like.

As the material of the electrode (positive electrode) 8 and the electrode (negative electrode) 9, there can be mentioned, for example, metals such as aluminum, gold, silver and platinum; conductive metal oxides such as indium tin oxide (ITO), indium zinc oxide (IZO), and zinc oxide (ZnO); organic conductive materials such as conductive polymers; and carbon-based materials such as nanotubes. Examples of a method for forming the electrode (positive electrode) 8 and the electrode (negative electrode) 9 include a vacuum vapor deposition method, a sputtering method, a coating method, and the like.

### <Solar Cell>

The solar cell of the present invention has the photoelectric conversion element. In the solar cell of the present invention, the configuration other than the light absorption layer is not particularly limited, and a known solar cell configuration can be applied. The solar cell of the present invention may be an intermediate-band solar cell.

The present invention and preferred embodiments of the present invention are described below.
<1> A light absorption layer comprising quantum dots dispersed in a matrix of one or more perovskite compounds selected from a compound represented by the following general formula (1) and a compound represented by the following general formula (2):

   RMX₃ (1)

   wherein R is two or more of monovalent cations, M is a divalent metal cation, and X is a halogen anion,

   R¹R²R³ₙ₋₁MₙX₃ₙ₊₁ (2)

   wherein R¹, R², and R³ are each independently a monovalent cation, at least two of R¹, R², and R³ are different monovalent cations, and at least one of R¹, R², and R³ is a monovalent inorganic cation, M is a divalent metal cation, X is a halogen anion, and n is an integer of 1 or more and 10 or less.
<2> The light absorption layer according to <1>, wherein the perovskite compound is preferably a compound represented by the general formula (1).
<3> The light absorption layer according to <1> or <2>, wherein the R is an inorganic cation of a group 1 element of the periodic table and an organic cation, the inorganic cation of a group 1 element of the periodic table is preferably one or more selected from K⁺, Rb⁺, and Cs⁺, more preferably one or more selected from Rb⁺ and Cs⁺, still more preferably Cs⁺, and the organic cation is one or more selected from an ammonium ion which may have a substituent and a phosphonium ion which may have a substituent, the ammonium ion which may have a substituent is preferably one or more kinds selected from an alkylammonium ion, a formamidinium ion and an arylammonium ion, more preferably one or more kinds selected from an alkyl ammonium ion and a formamidinium ion, still more preferably one or more kinds selected from a monoalkylammonium ion and a formamidinium ion, even still more preferably one or more kinds selected from a methylammonium ion, an ethylammonium ion, a butylammonium ion and a formamidinium ion, and even still more preferably a methylammonium ion.
<4> The light absorption layer according to <1> or <2>, wherein the R is preferably a combination of an inorganic cation and an organic cation, more preferably a combination of one or more selected from K⁺, Rb⁺, and Cs⁺ and one or more selected from alkylammonium ion and formamidinium ion, still more preferably a combination of one or more selected from Rb⁺ and Cs⁺ and one or more selected from methylammonium ion, ethylammonium ion, butylammonium ion, and formamidinium ion, even still more preferably a combination of Cs⁺ and methylammonium ion.
<5> The light absorption layer according to any one of <1> to <4>, wherein the monovalent cation contained most in the R is an organic cation, and the monovalent cation contained minimum in the R is an inorganic cation.
<6> The light absorption layer according to <5>, wherein the molar ratio of the minimum contained monovalent cation to the total monovalent cations is preferably 0.01 or more, more preferably 0.05 or more, still more preferably 0.08 or more, even still more preferably 0.09 or more, and preferably 0.4 or less, more preferably 0.3 or less, still more preferably 0.2 or less, even still more preferably 0.15 or less, and the molar ratio of the most contained monovalent cation to the total amount of monovalent cations is preferably 0.3 or more, more preferably 0.5 or more, still more preferably 0.8 or more. even still more preferably 0.85 or more, and preferably 0.99 or less, more preferably 0.95 or less, still more preferably 0.93 or less, even still more preferably 0.91 or less.
<7> The light absorption layer according to <5>, wherein
   preferably, the molar ratio of the minimum contained monovalent cation to the total monovalent cations is 0.01 or more and 0.4 or less, and the molar ratio of the most contained monovalent cation to the total amount of monovalent cations is 0.3 or more and 0.99 or less,
   more preferably, the molar ratio of the minimum contained monovalent cation to the total monovalent cations is 0.05 or more and 0.3 or less, and the molar ratio of the most contained monovalent cation to the total amount of monovalent cations is 0.5 or more and 0.95 or less,
   still more preferably, the molar ratio of the minimum contained monovalent cation to the total monovalent cations is 0.08 or more and 0.2 or less, and the molar ratio of the most contained monovalent cation to the total amount of monovalent cations is 0.8 or more and 0.93 or less,
   even still more preferably, the molar ratio of the minimum contained monovalent cation to the total monovalent cations is 0.09 or more and 0.15 or less, and the molar ratio of the most contained monovalent cation to the total amount of monovalent cations is 0.85 or more and 0.91 or less.
<8> The light absorption layer according to any one of <1> to <7>, wherein the R¹, the R², and the R³ are an inorganic cation of a group 1 element of the periodic table and an organic cation, the inorganic cation of a group 1 element of the periodic table is preferably at least one selected from K⁺, Rb⁺, and Cs⁺, more preferably at least one selected from Rb⁺ and Cs⁺, still more preferably Cs⁺, and the organic cation is preferably at least one selected from an ammonium ion which may have a substituent and a phosphonium ion which may have a substituent, the ammonium ion which may have a substituent is preferably one or more kinds selected from an alkylammonium ion, a formamidinium ion and an arylammonium ion, more preferably one or more kinds selected from an alkylammonium ion and a formamidinium ion, still more preferably one or more kinds selected from a monoalkylammonium ion and a formamidinium ion, even still more preferably one or more kinds selected from a methylammonium ion, an ethylammonium ion, a butylammonium ion, a hexylammonium ion, an octylammonium ion, a decylammonium ion, a dodecyl ammonium ion, a tetradecyl ammonium ion, a hexadecyl ammonium ion, and an octadecyl ammonium ion, even still more preferably a methylammonium ion.
<9> The light absorption layer according to any one of <1> to <8>, wherein the combination of the R¹, the R² and the R³ is preferably a combination of an inorganic cation, an inorganic cation and an organic cation, or a combination of an inorganic cation, an organic cation and an organic cation, more preferably a combination of an inorganic cation, an organic cation and an organic cation.
<10> The light absorption layer according to any one of <1> to <9>, wherein the R¹ is an alkylammonium ion or a formamidinium ion, and the R² is K⁺, Rb⁺, or Cs⁺.
<11> The light absorption layer according to any one of <1> to <10>, wherein the n is preferably 1 to 4.
<12> The light absorption layer according to any one of <1> to <11>, wherein the M is preferably Pb²⁺, Sn²⁺, or Ge²⁺, more preferably Pb²⁺ or Sn²⁺, still more preferably Pb²⁺.
<13> The light absorption layer according to any one of <1> to <12>, wherein the X is preferably a chlorine anion, a bromine anion or an iodine anion, more preferably a bromine anion or an iodine anion, still more preferably an iodine anion.
<14> The light absorption layer according to any one of <1> to <13>, wherein the compound represented by the general formula (1) is preferably one or more selected from Cs_{0.1}(CH₃NH₃)_{0.9}PbBr₃ and Cs_{0.1}(CH₃NH₃)_{0.9}PbI₃, more preferably Cs_{0.1}(CH₃NH₃)_{0.9}PbI₃.
<15> The light absorption layer according to any one of <1> to <14>, wherein the compound represented by the general formula (2) is preferably one or more selected from Cs_{0.1}(C₁₂H₂₅NH₃)_{1.9}PbI₄, Cs_{0.1}(C₁₂H₂₅NH₃)_{1.9}(CH₃NH₃)Pb₂I₇, and Cs_{0.1}(C₁₂H₂₅NH₃)_{1.9}(CH₃NH₃)₂Pb₃I₁₀, more preferably one or more selected from Cs_{0.1}(C₁₂H₂₅NH₃)_{1.9}PbI₄ and Cs_{0.1}(C₁₂H₂₅NH₃)_{1.9}(CH₃NH₃)Pb₂I₇.
<16> The light absorption layer according to any one of <1> to <15>, wherein the band gap energy of the perovskite compound is preferably 1.0 eV or more, more preferably 1.3 eV or more, still more preferably 1.5 eV or more, and is preferably 3.0 eV or less, more preferably 2.0 eV or less, still more preferably 1.7 eV or less.
<17> The light absorption layer according to any one of <1> to <16>, wherein the ratio of the strongest peak intensity of the metal halide salt to the strongest peak intensity of the perovskite compound is preferably 0.01 or more, more preferably 0.05 or more, still more preferably 0.1 or more, and is preferably 1 or less, more preferably 0.7 or less, still more preferably 0.4 or less.
<18> The light absorption layer according to any one of <1> to <15>, wherein
   preferably, the band gap energy of the perovskite compound is preferably 1.0 eV or more and 3.0 eV or less, and the ratio of the strongest peak intensity of the metal halide salt to the strongest peak intensity of the perovskite compound is preferably 0.01 or more and 1 or less,
   more preferably, the band gap energy of the perovskite compound is preferably 1.3 eV or more and 2.0 eV or less, and the ratio of the strongest peak intensity of the metal halide salt to the strongest peak intensity of the perovskite compound is preferably 0.05 or more and 0.7 or less,
   still more preferably, the band gap energy of the perovskite compound is preferably 1.5 eV or more and 1.7 eV or less, and the ratio of the strongest peak intensity of the metal halide salt to the strongest peak intensity of the perovskite compound is preferably 0.1 or more and 0.4 or less.
<19> The light absorption layer according to any one of <1> to <18>, wherein the crystallite diameter of the perovskite compound of the light absorption layer is preferably 10 nm or more, more preferably 20 nm or more, still more preferably 27 nm or more, and is preferably 1000 nm or less.
<20> The light absorption layer according to any one of <1> to <19>, wherein the band gap energy of the quantum dot is 0.2 eV or more and less than the band gap energy of the perovskite compound.
<21> The light absorption layer according to any one of <1> to <20>, wherein the band gap energy of the quantum dot is preferably 0.8 eV or more, more preferably 0.9 eV or more, still more preferably 1.0 eV or more, and is preferably 1.6 eV or less, more preferably 1.5 eV or less, still more preferably 1.4 eV or less, even still more preferably 1.3 eV or less.
<22> The light absorption layer according to any one of <1> to <21>, wherein
   preferably, the band gap energy of the perovskite compound is preferably 1.0 eV or more and 3.0 eV or less, and the band gap energy of the quantum dot is preferably 0.8 eV or more and 1.6 eV or less,
   more preferably, the band gap energy of the perovskite compound is preferably 1.3 eV or more and 2.0 eV or less, and the band gap energy of the quantum dot is preferably 0.9 eV or more and 1.5 eV or less,
   still more preferably, the band gap energy of the perovskite compound is preferably 1.5 eV or more and 1.7 eV or less, and the band gap energy of the quantum dot is preferably 1.0 eV or more and 1.4 eV or less,
   even still more preferably, the band gap energy of the perovskite compound is preferably 1.5 eV or more and 1.7 eV or less, and the band gap energy of the quantum dot is preferably 1.0 eV or more and 1.3 eV or less.
<23> The light absorption layer according to any one of <1> to <22>, wherein the difference between the band gap energy of the perovskite compound and the band gap energy of the quantum dot is preferably 0.2 eV or more, more preferably 0.3 eV or more, still more preferably 0.4 eV or more, even still more preferably 0.5 eV or more, and preferably 2.0 eV or less, more preferably 1.5 eV or less, still more preferably 1.0 eV or less, even still more preferably 0.8 eV or less, even still more preferably 0.7 eV or less.
<24> The light absorption layer according to any one of <1> to <23>, wherein
   preferably, the band gap energy of the perovskite compound is preferably 1.0 eV or more and 3.0 eV or less, the band gap energy of the quantum dot is preferably 0.8 eV or more and 1.6 eV or less, and the difference between the band gap energy of the perovskite compound and the band gap energy of the quantum dot is preferably 0.2 eV or more and 2.0 eV or less,
   more preferably, the band gap energy of the perovskite compound is preferably 1.3 eV or more and 2.0 eV or less, the band gap energy of the quantum dot is preferably 0.9 eV or more and 1.5 eV or less, and the difference between the band gap energy of the perovskite compound and the band gap energy of the quantum dot is preferably 0.3 eV or more and 1.0 eV or less,
   still more preferably, the band gap energy of the perovskite compound is preferably 1.5 eV or more and 1.7 eV or less, the band gap energy of the quantum dot is preferably 1.0 eV or more and 1.4 eV or less, and the difference between the band gap energy of the perovskite compound and the band gap energy of the quantum dot is preferably 0.4 eV or more and 0.7 eV or less.
<25> The light absorption layer according to any one of <1> to <24>, wherein the particle diameter of the quantum dot is preferably 1 nm or more, more preferably 2 nm or more, still more preferably 3 nm or more, and preferably 20 nm or less, more preferably 10 nm or less, still more preferably 5 nm or less.
<26> The light absorption layer according to any one of <1> to <25>, wherein the quantum dot contains metal oxide or metal chalcogenide.
<27> The light absorption layer according to any one of <1> to <26>, wherein the quantum dot preferably contains Pb element, more preferably PbS or PbSe, still more preferably PbS.
<28> The light absorption layer according to any one of <1> to <27>, wherein the quantum dot includes a quantum dot containing a halogen element-containing substance as a ligand, or a quantum dot containing an organic compound and a halogen element-containing substance as ligands.
<29> The light absorption layer according to <28>, wherein the organic compound as a ligand is preferably a carboxy group-containing compound, or an amino group-containing compound, more preferably a carboxy group-containing compound, still more preferably fatty acid having 8 or more carbon atoms, even still more preferably fatty acid having 12 or more carbon atoms, even still more preferably oleic acid.
<30> The light absorption layer according to <28> or <29>, wherein the molar ratio of the organic ligand to the metal element constituting the quantum dot is preferably 0.001 or more, more preferably 0.005 or more, still more preferably 0.01 or more, and preferably 0.6 or less, more preferably 0.1 or less, still more preferably 0.05 or less.
<31> The light absorption layer according to any one of <28> to <30>, wherein the halogen element of the halogen element-containing substance as the ligand is preferably iodine or bromine, more preferably iodine.
<32> The light absorption layer according to any one of <28> to <30>, wherein the halogen element-containing substance as the ligand is iodine.
<33> The light absorption layer according to any one of <28> to <32>, wherein the atomic ratio of the halogen element to the metal element constituting the quantum dot is preferably 0.1 or more, more preferably 0.2 or more, still more preferably 0.3 or more, and preferably 1 or less, more preferably 0.8 or less, still more preferably 0.7 or less.
<34> The light absorption layer according to any one of <1> to <33>, wherein a combination of the perovskite compound and the quantum dot is a combination of Cs_{0.1}(CH₃NH₃)_{0.9}PbI₃ and PbS.
<35> The light absorption layer according to any one of <1> to <34>, wherein the light absorption layer has an intermediate-band.
<36> The light absorption layer according to any one of <1> to <35>, wherein the content ratio of the quantum dot to the total content of the perovskite compound and the quantum dot in the light absorption layer is preferably 7.5% by mass or more, more preferably 10% by mass or more, still more preferably 15% by mass or more, even still more preferably 17% by mass or more, and is preferably 40% by mass or less, more preferably 30% by mass or less, still more preferably 25% by mass or less.
<37> The light absorption layer according to any one of <1> to <36>, wherein the distance between the quantum dot particles in the light absorption layer is preferably 10 nm or less, more preferably 6 nm or less, still more preferably 4.5 nm or less.
<38> The light absorption layer according to any one of <1> to <37>, wherein the particle density of the quantum dots in the light absorption layer is preferably 1 × 10¹⁰/_{cm}² or more, more preferably 1 × 10¹¹/cm² or more, still more preferably 1 × 10¹²/cm² or more, even still more preferably 2.2 × 10¹²/cm² or more, and is preferably 1 × 10¹⁴/cm² or less, more preferably 1 × 10¹³/cm² or less, and still more preferably 5 × 10¹²/cm² or less.
<39> The light absorption layer according to any one of <1> to <38>, wherein
   preferably, the content ratio of the quantum dot to the total content of the perovskite compound and the quantum dot in the light absorption layer is 7.5% by mass or more and 40% by mass or less, and the distance between the quantum dot particles in the light absorption layer is 10 nm or less,
   more preferably, the content ratio of the quantum dot to the total content of the perovskite compound and the quantum dot in the light absorption layer is 10% by mass or more and 30% by mass or less, and the distance between the quantum dot particles in the light absorption layer is 6 nm or less,
   still more preferably, the content ratio of the quantum dot to the total content of the perovskite compound and the quantum dot in the light absorption layer is 15% by mass or more and 25% by mass or less, and the distance between the quantum dot particles in the light absorption layer is 4.5 nm or less,
   even still more preferably, the content ratio of the quantum dot to the total content of the perovskite compound and the quantum dot in the light absorption layer is 17% by mass or more and 25% by mass or less, and the distance between the quantum dot particles in the light absorption layer is 4.5 nm or less.
<40> The light absorption layer according to any one of <1> to <38>, wherein
   preferably, the content ratio of the quantum dot to the total content of the perovskite compound and the quantum dot in the light absorption layer is 7.5% by mass or more and 40% by mass or less, and the particle density of the quantum dots in the light absorption layer is 1 × 10¹⁰/cm² or more and 1 × 10¹⁴/cm² or less,
   more preferably, the content ratio of the quantum dot to the total content of the perovskite compound and the quantum dot in the light absorption layer is 10% by mass or more and 30% by mass or less, and the particle density of the quantum dots in the light absorption layer is 1 × 10¹¹/cm² or more and 1 × 10¹³/cm² or less,
   still more preferably, the content ratio of the quantum dot to the total content of the perovskite compound and the quantum dot in the light absorption layer is 15% by mass or more and 25% by mass or less, and the particle density of the quantum dots in the light absorption layer is 1 × 10¹²/cm² or more and 5 × 10¹²/cm² or less,
   even still more preferably, the content ratio of the quantum dot to the total content of the perovskite compound and the quantum dot in the light absorption layer is 17% by mass or more and 25% by mass or less, and the particle density of the quantum dots in the light absorption layer is 2.2 × 10¹²/cm² or more and 5 × 10¹²/cm² or less.
<41> The light absorption layer according to any one of <1> to <38>, wherein
   preferably, the content ratio of the quantum dot to the total content of the perovskite compound and the quantum dot in the light absorption layer is 7.5% by mass or more and 40% by mass or less, the distance between the quantum dot particles in the light absorption layer is 10 nm or less, and the particle density of the quantum dots in the light absorption layer is 1 × 10¹⁰/cm² or more and 1 × 10¹⁴/cm² or less,
   more preferably, the content ratio of the quantum dot to the total content of the perovskite compound and the quantum dot in the light absorption layer is 10% by mass or more and 30% by mass or less, the distance between the quantum dot particles in the light absorption layer is 6 nm or less, and the particle density of the quantum dots in the light absorption layer is 1 × 10¹¹/cm² or more and 1 × 10¹³/cm² or less,
   still more preferably, the content ratio of the quantum dot to the total content of the perovskite compound and the quantum dot in the light absorption layer is 15% by mass or more and 25% by mass or less, the distance between the quantum dot particles in the light absorption layer is 4.5 nm or less, and the particle density of the quantum dots in the light absorption layer is 1 × 10¹²/cm² or more and 5 × 10¹²/cm² or less,
   even still more preferably, the content ratio of the quantum dot to the total content of the perovskite compound and the quantum dot in the light absorption layer is 17% by mass or more and 25% by mass or less, the distance between the quantum dot particles in the light absorption layer is 4.5 nm or less, and the particle density of the quantum dots in the light absorption layer is 2.2 × 10¹²/cm² or more and 5 × 10¹²/cm² or less.
<42> The light absorption layer according to any one of <1> to <41>, wherein the external quantum efficiency difference (ΔEQE) at 700 nm of the light absorption layer is preferably 0.1% or more, more preferably 0.5% or more, still more preferably 1% or more.
<43> The light absorption layer according to any one of <1> to <42>, wherein the external quantum efficiency difference (ΔEQE) at 900 nm of the light absorption layer is preferably 0.01% or more, more preferably 0.03% or more, still more preferably 0.05% or more.
<44> The light absorption layer according to any one of <1> to <43>, wherein the external quantum efficiency difference (ΔEQE) at 1100 nm of the light absorption layer is preferably 0.005% or more, more preferably 0.01% or more, still more preferably 0.02% or more.
<45> The light absorption layer according to any one of <1> to <44>, wherein
   preferably, the external quantum efficiency difference (ΔEQE) at 700 nm of the light absorption layer is 0.1% or more, the external quantum efficiency difference (ΔEQE) at 900 nm of the light absorption layer is 0.01% or more, and the external quantum efficiency difference (ΔEQE) at 1100 nm of the light absorption layer is 0.005% or more,
   more preferably, the external quantum efficiency difference (ΔEQE) at 700 nm of the light absorption layer is 0.5% or more, the external quantum efficiency difference (ΔEQE) at 900 nm of the light absorption layer is 0.03% or more, and the external quantum efficiency difference (ΔEQE) at 1100 nm of the light absorption layer is 0.01% or more,
   still more preferably, the external quantum efficiency difference (ΔEQE) at 700 nm of the light absorption layer is 1% or more, the external quantum efficiency difference (ΔEQE) at 900 nm of the light absorption layer is 0.05% or more, and the external quantum efficiency difference (ΔEQE) at 1100 nm of the light absorption layer is 0.02% or more.
<46> The light absorption layer according to any one of <35> to <45>, wherein the energy difference between the valence band of the perovskite compound and the intermediate-band is preferably 1.0 eV or more, more preferably 1.2 eV or more, still more preferably 1.3 eV or more, and is preferably 2.0 eV or less, more preferably 1.6 eV or less, still more preferably 1.4 eV or less.
<47> The light absorption layer according to any one of <35> to <46>, wherein the energy difference between the intermediate-band and the conduction band of the perovskite compound is preferably 0.1 eV or more, more preferably 0.2 eV or more, still more preferably 0.3 eV or more, and is preferably 1.5 eV or less, more preferably 0.8 eV or less, still more preferably 0.6 eV or less.
<48> The light absorption layer according to any one of <35> to <47>, wherein
   preferably, the energy difference between the valence band of the perovskite compound and the intermediate-band is 1.0 eV or more and 2.0 eV or less, and the energy difference between the intermediate-band and the conduction band of the perovskite compound is 0.1 eV or more and 1.5 eV or less,
   more preferably, the energy difference between the valence band of the perovskite compound and the intermediate-band is 1.2 eV or more and 1.6 eV or less, and the energy difference between the intermediate-band and the conduction band of the perovskite compound is 0.2 eV or more and 0.8 eV or less,
   still more preferably, the energy difference between the valence band of the perovskite compound and the intermediate-band is 1.3 eV or more and 1.4 eV or less, and the energy difference between the intermediate-band and the conduction band of the perovskite compound is 0.3 eV or more and 0.6 eV or less.
<49> The light absorption layer according to any one of <1> to <48>, wherein the external quantum efficiency (EQE) of the light absorption layer at 500 nm is preferably 10% or more, more preferably 30% or more, still more preferably 40% or more.
<50> The light absorption layer according to any one of <1> to <49>, wherein the external quantum efficiency (EQE) ratio of the light absorption layer to the EQE of a light absorption layer of the perovskite compound alone at 500 nm is preferably 0.1 or more, more preferably 0.3 or more, and still more preferably 0.55 or more.
<51> The light absorption layer according to any one of <1> to <50>, wherein
   preferably, the external quantum efficiency (EQE) of the light absorption layer at 500 nm is 10% or more, and the external quantum efficiency (EQE) ratio of the light absorption layer to the EQE of a light absorption layer of the perovskite compound alone at 500 nm is 0.1 or more,
   more preferably, the external quantum efficiency (EQE) of the light absorption layer at 500 nm is 30% or more, and the external quantum efficiency (EQE) ratio of the light absorption layer to the EQE of a light absorption layer of the perovskite compound alone at 500 nm is 0.3 or more,
   still more preferably, the external quantum efficiency (EQE) of the light absorption layer at 500 nm is 40% or more, and the external quantum efficiency (EQE) ratio of the light absorption layer to the EQE of a light absorption layer of the perovskite compound alone at 500 nm is 0.55 or more.
<52> The light absorption layer according to any one of <1> to <51>, wherein the external quantum efficiency (EQE) of the light absorption layer at 900 nm is preferably 0.1% or more, more preferably 1% or more, still more preferably 1.5% or more.
<53> The light absorption layer according to any one of <1> to <52>, wherein
   preferably, the external quantum efficiency (EQE) of the light absorption layer at 500 nm is 10% or more, and the external quantum efficiency (EQE) of the light absorption layer at 900 nm is 0.1% or more,
   more preferably, the external quantum efficiency (EQE) of the light absorption layer at 500 nm is 30% or more, and the external quantum efficiency (EQE) of the light absorption layer at 900 nm is 1% or more,
   still more preferably, the external quantum efficiency (EQE) of the light absorption layer at 500 nm is 40% or more, and the external quantum efficiency (EQE) of the light absorption layer at 900 nm is 1.5% or more.
<54> The light absorption layer according to any one of <1> to <53>, wherein
   preferably, the external quantum efficiency (EQE) of the light absorption layer at 500 nm is 10% or more, the external quantum efficiency (EQE) ratio of the light absorption layer to the EQE of a light absorption layer of the perovskite compound alone at 500 nm is 0.1 or more, and the external quantum efficiency (EQE) of the light absorption layer at 900 nm is 0.1% or more,
   more preferably, the external quantum efficiency (EQE) of the light absorption layer at 500 nm is 30% or more, the external quantum efficiency (EQE) ratio of the light absorption layer to the EQE of a light absorption layer of the perovskite compound alone at 500 nm is 0.3 or more, and the external quantum efficiency (EQE) of the light absorption layer at 900 nm is 1% or more,
   still more preferably, the external quantum efficiency (EQE) of the light absorption layer at 500 nm is 40% or more, the external quantum efficiency (EQE) ratio of the light absorption layer to the EQE of a light absorption layer of the perovskite compound alone at 500 nm is 0.55 or more, and the external quantum efficiency (EQE) of the light absorption layer at 900 nm is 1.5% or more.
<55> The light absorption layer according to any one of <1> to <54>, wherein the thickness of the light absorption layer is preferably 30 nm or more, more preferably 50 nm or more, still more preferably 80 nm or more, and preferably 1000 nm or less, more preferably 800 nm or less, still more preferably 600 nm or less, even still more preferably 500 nm or less.
<56> The light absorption layer according to any one of <1> to <55>, wherein the surface smoothness of the light absorption layer is preferably 100 nm or more, more preferably 200 nm or more, still more preferably 300 nm or more, even still more preferably 400 nm or more, and preferably 1000 nm or less, more preferably 800 nm or less, still more preferably 700 nm or less.
<57> The light absorption layer according to any one of <1> to <56>, wherein the coverage of the light absorption layer to the porous layer is preferably 10% or more, more preferably 20% or more, still more preferably 30% or more, even still more preferably 40% or more, furthermore preferably 50% or more, and is 100% or less.
<58> The light absorption layer according to any one of <1> to <57>, wherein the absorbance ratio (QD/P) of the quantum dot (QD) to the perovskite compound (P) in the light absorption layer is preferably 0.3 or less, more preferably 0.2 or less, still more preferably 0.1 or less, even still more preferably 0.
<59> The light absorption layer according to any one of <1> to <58>, wherein when the light absorption layer is excited with light that is the band gap energy or more of the quantum dots and less than the band gap energy of the perovskite, the emission peak energy in the light absorption layer is preferably 0.2 eV or more, more preferably 0.4 eV or more, still more preferably 0.6 eV or more, even still more preferably 0.8 eV or more, and preferably 1.4 eV or less, more preferably 1.3 eV or less, still more preferably 1.2 eV or less, even still more preferably 1.1 eV or less.
<60> The light absorption layer according to any one of <1> to <59>, wherein the difference between the light emission peak energy in the light absorption layer and the band gap energy of the perovskite compound is preferably 0.2 eV or more, more preferably 0.4 eV or more, still more preferably 0.5 eV or more, and preferably 1.5 eV or less, more preferably 1.0 eV or less, still more preferably 0.7 eV or less.
<61> The light absorption layer according to any one of <1> to <60>, wherein the difference between the light emission peak energy in the light absorption layer and the band gap energy of the quantum dot is preferably 1.0 eV or less, more preferably 0.5 eV or less, still more preferably 0.3 eV or less, even still more preferably 0 eV.
<62> The light absorption layer according to any one of <1> to <61>, wherein
   preferably, the difference between the light emission peak energy in the light absorption layer and the band gap energy of the perovskite compound is 0.2 eV or more and 1.5 eV or less, and the difference between the light emission peak energy in the light absorption layer and the band gap energy of the quantum dot is 1.0 eV or less,
   more preferably, the difference between the light emission peak energy in the light absorption layer and the band gap energy of the perovskite compound is 0.4 eV or more and 1.0 eV or less, and the difference between the light emission peak energy in the light absorption layer and the band gap energy of the quantum dot is 0.5 eV or less,
   still more preferably, the difference between the light emission peak energy in the light absorption layer and the band gap energy of the perovskite compound is 0.5 eV or more and 0.7 eV or less, and the difference between the light emission peak energy in the light absorption layer and the band gap energy of the quantum dot is 0.3 eV or less,
   even still more preferably, the difference between the light emission peak energy in the light absorption layer and the band gap energy of the perovskite compound is 0.5 eV or more and 0.7 eV or less, and the difference between the light emission peak energy in the light absorption layer and the band gap energy of the quantum dot is 0 eV or less.
<63> A dispersion for manufacturing the light absorption layer according to any one of <1> to <62>, said dispersion comprising one or more perovskite compound selected from the compound represented by the general formula (1) and the compound represented by the general formula (2) and/or a precursor thereof, and a quantum dot containing, as a ligand, a halogen element-containing substance.
<64> A dispersion according to <63>, wherein the dispersion contains a solvent, and the solvent is preferably a polar solvent, more preferably at least one solvent selected from ketones, amide type solvents, and dimethylsulfoxide, still more preferably amide type solvents, even still more preferably N,N-dimethylformamide.
<65> A dispersion according to <63> or <64>, wherein the solid content concentration of the quantum dots in the dispersion is preferably 1 mg/mL or more, more preferably 10 mg/mL or more, still more preferably 50 mg/mL or more, and preferably 100 mg/mL or less, more preferably 80 mg/mL or less, still more preferably 60 mg/mL or less.
<66> A light absorption layer obtained from the dispersion according to any one of <63> to <65>.
<67> A method for manufacturing a light absorption layer comprising quantum dots dispersed in a matrix of one or more perovskite compounds selected from a compound represented by the following general formula (1) and a compound represented by the following general formula (2), and including the following step 1, step 2, and step 3:
   (step 1) a step of ligand-exchanging the organic ligand of an organic ligand-containing quantum dot to a halogen element-containing substance to obtain a quantum dot solid containing the halogen element-containing substance as a ligand,
   (step 2) a step of obtaining a dispersion by mixing the quantum dot solid obtained in step 1 with a solution or mixed solution containing one or more substances selected from a compound represented by the following general formula (1), a compound represented by the following general formula (2), and a precursor thereof,
   (step 3) a step of obtaining a light absorption layer from the dispersion obtained in step 2:

      RMX₃ (1)

      wherein R is two or more of monovalent cations, M is a divalent metal cation, and X is a halogen anion,

      R¹R²R³ₙ₋₁MₙX₃ₙ₊₁ (2)

      wherein R¹, R², and R³ are each independently a monovalent cation, at least two of R¹, R², and R³ are different monovalent cations, and at least one of R¹, R², and R³ is a monovalent inorganic cation, M is a divalent metal cation, X is a halogen anion, and n is an integer of 1 or more and 10 or less.
<68> The method for manufacturing a light absorption layer according to <67>, wherein the halogen element of the halogen element-containing substance is preferably iodine or bromine, more preferably iodine.
<69> The method for manufacturing a light absorption layer according to <67> or <68>, wherein a method for ligand exchange of an organic ligand of the quantum dot containing the organic ligand to a halogen element-containing substance is preferably a method of exchanging a ligand in a dispersion, more preferably a method in which a dispersion of the quantum dot containing the organic ligand and a raw material solution of a halogen element-containing substance are mixed over time at room temperature (25°C) without stirring and allowed to stand to perform ligand exchange.
<70> The method for manufacturing a light absorption layer according to any one of <67> to <69>, wherein the halogen element-containing substance raw material used for the ligand exchange is preferably one or more members selected from methylammonium iodide (methylamine hydroiodide), ammonium iodide, methylammonium bromide (methylamine hydrobromide), and ammonium bromide, more preferably one or more members selected from methylammonium iodide (methylamine hydroiodide) and methylammonium bromide (methylamine hydrobromide), still more preferably methylammonium iodide (methylamine hydroiodide).
<71> The method for manufacturing a light absorption layer according to any one of <67> to <70>, wherein the mixing amount of the halogen element-containing substance raw material used for ligand exchange is preferably 0.1 or more, more preferably 1 or more, still more preferably 1.5 or more, and preferably 10 or less, more preferably 8 or less, still more preferably 5 or less as the molar ratio of the halogen element to the organic compound on the quantum dot surface.
<72> The method for manufacturing a light absorption layer according to any one of <67> to <71>, wherein the solvent used for ligand exchange is a mixed solvent of a solvent capable of dispersing quantum dots well and a solvent capable of dissolving a halogen element-containing substance raw material, the solvent for dispersing the quantum dots is preferably one or more non-(low)polar organic solvents selected from toluene, hexane and octane, more preferably toluene, and the solvent for dissolving the halogen element-containing substance raw material is preferably at least one aprotic polar organic solvent selected from N,N-dimethylformamide, dimethyl sulfoxide and γ-butyrolactone, more preferably N,N-dimethylformamide.
<73> The method for manufacturing a light absorption layer according to any one of <67> to <72>, wherein the solid content concentration of the quantum dot in the quantum dot dispersion to be mixed at the time of ligand exchange is preferably 10 mg/mL or more, more preferably 50 mg/mL or more, still more preferably 80 mg/mL or more, and preferably 1000 mg/mL or less, more preferably 500 mg/mL or less, still more preferably 200 mg/mL or less.
<74> The method for manufacturing a light absorption layer according to any one of <67> to <73>, wherein the concentration of the halogen element-containing substance raw material in the halogen element-containing substance raw material solution to be mixed at the time of ligand exchange is preferably 0.01 mol/L or more, more preferably 0.1 mol/L or more, still more preferably 0.2 mol/L or more, and preferably 1 mol/L or less, more preferably 0.5 mol/L or less, still more preferably 0.3 mol/L or less.
<75> The method for manufacturing a light absorption layer according to any one of <67> to <74>, wherein the method of mixing the quantum dot dispersion and the halogen element-containing substance raw material solution at the time of ligand exchange is preferably a continuous method or a dropping method (semi-continuous method), more preferably a dropping method.
<76> The method for manufacturing a light absorption layer according to <75>, wherein the continuous method is a method of mixing a raw material solution of a halogen element-containing substance in a quantum dot dispersion, and the mixing speed is preferably 25 µl/sec or less, more preferably 5 µl/sec or less, still more preferably 3 µl/sec or less, and preferably 0.2 µl/sec or more, more preferably 0.4 µl/sec or more, still more preferably 1.5 µl/sec or more.
<77> The method for manufacturing a light absorption layer according to <75>, wherein the dropping method is a method of dropping a raw material solution of a halogen element-containing substance to a quantum dot dispersion, and the dropping rate is preferably 1 drop/1 second or less, more preferably 1 drop/5 seconds or less, still more preferably 1 drop/8 seconds or less, and preferably 1 drop/100 seconds or more, more preferably 1 drop/50 seconds or more, still more preferably 1 drop/15 seconds or more.
<78> The method for manufacturing a light absorption layer according to any one of <67> to <77>, wherein the time allowed to stand still the mixture after mixing the quantum dot dispersion and the halogen element-containing substance raw material solution is preferably 0.1 hours or more, more preferably 1 hour or more, still more preferably 10 hours or more, and preferably 100 hours or less, more preferably 48 hours or less, still more preferably 24 hours or less.
<79> The method for manufacturing a light absorption layer according to any one of <67> to <78>, wherein a method for obtaining a quantum dot solid having an organic compound and a halogen element-containing substance as the ligands after ligand exchange is preferably a method comprising adding a washing solvent to a mixture dispersion of a quantum dot dispersion and a halogen element-containing substance raw material solution and filtering the resulting mixture to remove the organic compound coordinated on the surface of the quantum dot, the excess halogen element-containing substance raw material and the solvent.
<80> The method for manufacturing a light absorption layer according to <79>, wherein the washing solvent is preferably an organic solvent in which any quantum dots before and after ligand exchange are hardly dispersed and an organic compound and a halogen element-containing substance are soluble, more preferably alcohol solvent, and still more preferably methanol.
<81> The method for manufacturing a light absorption layer according to <79> or <80>, wherein the amount of the washing solvent is preferably 0.1 or more, more preferably 0.5 or more, still more preferably 1 or more, and preferably 10 or less, more preferably 5 or less, still more preferably 2 or less, as the volume ratio of the washing solvent to the amount of the mixed dispersion of the quantum dot dispersion and the halogen element-containing substance raw material solution.
<82> The method for manufacturing a light absorption layer according to any one of <79> to <81>, wherein the filter pore size at the time of filtration is preferably 0.1 µm or more, more preferably 0.2 µm or more, and preferably 1 µm or less, more preferably 0.5 µm or less.
<83> The method for manufacturing a light absorption layer according to any one of <79> to <82>, wherein the filter material is preferably a hydrophobic material, more preferably polytetrafluoroethylene (PTFE).
<84> The method for manufacturing a light absorption layer according to any one of <67> to <83>, wherein the dispersion containing the perovskite compound and/or its precursor and the quantum dots preferably contains a solvent.
<85> The method for manufacturing a light absorption layer according to <84>, wherein the solvent is preferably a polar solvent, more preferably at least one solvent selected from ketones, amide type solvents, and dimethylsulfoxide, still more preferably amide type solvents, even still more preferably N,N-dimethylformamide.
<86> The method for manufacturing a light absorption layer according to <84> or <85>, wherein the metal concentration of the perovskite compound and/or its precursor in the dispersion is preferably 0.1 mol/L or more, more preferably 0.2 mol/L or more, still more preferably 0.3 mol/L or more, and preferably 1.5 mol/L or less, more preferably 1.0 mol/L or less, still more preferably 0.5 mol/L or less.
<87> The method for manufacturing a light absorption layer according to any one of <84> to <86>, wherein the solid content concentration of the quantum dots in the dispersion is preferably 1 mg/mL or more, more preferably 10 mg/mL or more, still more preferably 50 mg/mL or more, and preferably 100 mg/mL or less, more preferably 80 mg/mL or less, still more preferably 60 mg/mL or less.
<88> The method for manufacturing a light absorption layer according to any one of <84> to <87>, wherein
   preferably, the metal concentration of the perovskite compound and/or its precursor in the dispersion is 0.1 mol/L or more and 1.5 mol/L or less, and the solid content concentration of the quantum dots in the dispersion is 1 mg/mL or more and 100 mg/mL or less,
   more preferably, the metal concentration of the perovskite compound and/or its precursor in the dispersion is 0.2 mol/L or more and 1.0 mol/L or less, and the solid content concentration of the quantum dots in the dispersion is 10 mg/mL or more and 80 mg/mL or less,
   still more preferably, the metal concentration of the perovskite compound and/or its precursor in the dispersion is 0.3 mol/L or more and 0.5 mol/L or less, and the solid content concentration of the quantum dots in the dispersion is 50 mg/mL or more and 60 mg/mL or less.
<89> The method for manufacturing a light absorption layer according to any one of <67> to <88>, wherein the mixing temperature at preparing the dispersion is preferably 0°C or more, more preferably 10°C or more, still more preferably 20°C or more, and preferably 50°C or less, more preferably 40°C or less, still more preferably 30°C or less.
<90> The method for manufacturing a light absorption layer according to any one of <67> to <89>, wherein the mixing time at preparing the dispersion is preferably more than 0 hour, more preferably 0.1 hours or more, and preferably 72 hours or less, more preferably 24 hours or less, still more preferably 1 hour or less.
<91> The method for manufacturing a light absorption layer according to any one of <67> to <90>, wherein
   preferably, the mixing temperature at preparing the dispersion is 0°C or more and 50°C or less, and the mixing time at preparing the dispersion is more than 0 hour and 72 hours or less,
   more preferably, the mixing temperature at preparing the dispersion is 10°C or more and 40°C or less, and the mixing time at preparing the dispersion is 0.1 hours or more and 24 hours or less,
   still more preferably, the mixing temperature at preparing the dispersion is 20°C or more and 30°C or less, and the mixing time at preparing the dispersion is 0.1 hours or more and 1 hours or less.
<92> The method for manufacturing a light absorption layer according to any one of <67> to <91>, wherein the dispersion is filtered, the filter pore diameter at the time of filtration is preferably 0.1 µm or more, more preferably 0.2 µm or more, and preferably 1 µm or less, more preferably 0.5 µm or less, and the filter material is preferably a hydrophobic material, more preferably polytetrafluoroethylene (PTFE).
<93> The method for manufacturing a light absorption layer according to any one of <67> to <92>, wherein the step 3 is preferably a wet process, more preferably a spin coating method.
<94> The method for manufacturing a light absorption layer according to <93>, wherein the maximum rotation speed of the spin coating method is preferably 500 rpm or more, more preferably 1000 rpm or more, still more preferably 2000 rpm or more, and preferably 6000 rpm or less, more preferably 5000 rpm or less, still more preferably 4000 rpm or less.
<95> The method for manufacturing a light absorption layer according to <93> or <94>, wherein a poor solvent during spin coating is dropped in the spin coating method.
<96> The method for manufacturing a light absorption layer according to <95>, wherein the poor solvent is toluene or chlorobenzene.
<97> The method for manufacturing a light absorption layer according to any one of <93> to <96>, wherein a drying method in the wet process is the thermal drying, the temperature of the thermal drying is preferably 60°C or more, more preferably 80°C or more, still more preferably 100°C or more, and preferably 200°C or less, more preferably 150°C or less, still more preferably 120°C or less, and the time for thermal drying is preferably 1 minute or more, more preferably 5 minutes or more, still more preferably 10 minutes or more, and preferably 120 minutes or less, more preferably 60 minutes or less, still more preferably 30 minutes or less.
<98> A photoelectric conversion element having the light absorption layer according to any one of <1> to <62> and <66>.
<99> A solar cell having the photoelectric conversion element according to <98>.

### EXAMPLES

Hereinafter, the present invention will be described specifically based on Examples. Unless otherwise indicated in the table, the content of each component is % by mass. In addition, the evaluation/measurement method are as follows. In addition, unless otherwise noted, the implementation and measurement were carried out at 25°C.

### <I-V Curve>

Using an I-V characteristic measuring device (PECK 2400-N, manufactured by Peccell Technologies, Inc.) with a xenon-lamp white light as a light source (PEC-L01, manufactured by Peccell Technologies, Inc.) at a light intensity (100 mW/cm²) equivalent to sunlight (AM 1.5) under a mask of light irradiation area 0.0363 cm² (2 mm square), an I-V curve of the cell was measured under the conditions of a scanning speed of 0.1 V/sec (0.01 V step), a waiting time of 50 msec after voltage setting, a measurement integration time of 50 msec, a starting voltage of -0.1 V, and an ending voltage of 1.1 V. The light intensity was corrected with a silicon reference (BS-520, 0.5714 mA). The short-circuit current density (mA/cm²), open circuit voltage (V), fill factor (FF), and conversion efficiency (%) were determined from the I-V curve.

### <External Quantum Efficiency>

An external quantum efficiency (EQE) spectrum is measured by a direct current method in a wavelength range of 300 to 1200 nm under a mask with a light irradiation area of 0.0363 cm² using a spectral response measurement system (CEP-2000 MLR manufactured by Bunkoukeiki Co., Ltd.). The EQE at a wavelength of 500 nm derived from the light absorption of the perovskite compound and the EQE of 900 nm derived from the light absorption of the quantum dots were determined. In addition, in the EQE of 500 nm derived from the light absorption of the perovskite compound, the ratio of the EQE of a quantum dot composite cell to the EQE of a perovskite single cell was calculated.

### <External Quantum Efficiency Difference>

The external quantum efficiency difference (ΔEQE) was obtained by measuring the quantum efficiency (EQE) in the presence or absence of infrared-bias light irradiation using an optical chopper in a spectral response measurement system (CEP-1500, manufactured by Bunkoukeiki Co., Ltd.) and determining the difference (ΔEQE) between the EQE at the time of infrared bias light irradiation and the EQE at the time of no infrared bias light irradiation. Infrared bias light obtained by passing a pseudo-sunlight source of a xenon lamp with AM 1.5 filter through a long pass filter of 850 nm and 1400 nm was used. The modulation frequency of the infrared chopper was 5 Hz. Measurement was carried out by an alternating current method under a mask with a light irradiation area of 0.0361 cm² in the wavelength range of 300 to 1300 nm. The external quantum efficiency differences (ΔEQE) at wavelengths of 700 nm, 900 nm, and 1100 nm were determined.

### <Absorption Spectrum>

Using a UV-Vis spectrophotometer (SolidSpec-3700, manufactured by Shimadzu Corporation) under the conditions of a scanning speed of medium speed, a sample pitch of 1 nm, a slit width of 20, and an integrating sphere detector unit, the absorption spectrum of the light absorption layer was measured in the range of 300 to 1600 nm on a sample before applying the hole transport material. Background measurement was carried out with a fluorine-doped tin oxide (FTO) substrate (manufactured by Asahi Glass Fabritec Co., Ltd., 25 × 25 × 1.8 mm).

The absorption spectrum of the PbS quantum dot dispersion was similarly measured in a dispersion having a concentration of 0.1 mg/mL of PbS quantum dot solid using a 1 cm square quartz cell.

In the case of PbS quantum dot in which oleic acid was coordinated, hexane was used as a dispersion solvent, and in the case of PbS quantum dot in which iodine was coordinated, N,N-dimethylformamide (DMF) was used as a dispersion solvent.

Note that the absorption spectrum of the horizontal axis representing the wavelength λ and the vertical axis representing the absorbance A was converted into the spectrum of the horizontal axis representing the energy hν and the vertical axis representing (αhν)^{1/2} (α; absorption coefficient), and a straight line was fitted to the rising part of absorption and the intersection of the straight line and the baseline was taken as the band gap energy.

### <Emission spectrum>

The emission spectrum of the PbS quantum dot dispersion was measured with a near-infrared fluorescence spectrometer (Fluorolog, manufactured by Horiba Seisakusho Co., Ltd.) in the range of 850 to 1550 nm using a 1 cm square tetrahedral transparent cell in a hexane dispersion having a concentration of 0.1 mg/mL of PbS quantum dot solid under the conditions of an excitation wavelength of 800 nm, an excitation light slit-width of 10 nm, an emission slit-width of 15 nm, an acquisition time of 0.1 sec, an average of two times integrations, and dark offset on.

### <X-Ray Diffraction Analysis>

The crystallite diameter of the perovskite compound of the light absorption layer was determined in the range of 5 to 60° on a sample before applying a hole transport material by using a powder X-ray diffractometer (MiniFlex 600, light source Cu Kα, tube voltage 40 kV, tube current 15 mA, manufactured by Rigaku Corporation) under the conditions of a sampling width of 0.02°, a scanning speed of 20°/min, a solar slit (incident) of 5.0°, a divergence slit of 1.250°, a vertical divergence of 13.0 mm, a scattering slit of 13.0 mm, a solar slit (reflection) of 5.0°, and a receiving slit of 13.0 mm. The crystallite diameter of the perovskite compound was calculated at the strongest peak (2θ=14°) of the perovskite compound using an analysis software (PDXL, ver. 2.6.1.2). The ratio of the strongest peak (2θ=12°) intensity of lead iodide (PbI₂) to the strongest peak (2θ=14°) intensity of the perovskite compound was calculated.

The crystallite diameter (particle size) of the PbS quantum dot was measured similarly in a PbS quantum dot solid on a glass holder and calculated at the cubic (220) peak (2θ=42°) of PbS using an analysis software (PDXL, ver. 2.6.1.2).

### <Composition of PbS Quantum Dot Solid>

The Pb concentration in the PbS quantum dot solid was quantified by high frequency inductively coupled plasma-atomic emission spectroscopy (ICP) after completely dissolving the PbS quantum dot solid in a mixed solution of nitric acid and hydrogen peroxide.

The concentration of oleic acid in the PbS quantum dot solid was quantified by a proton (¹H) nuclear magnetic resonance (NMR) method in a deuterated toluene solvent (99 atom% D, containing 0.03 vol% TMS, manufactured by Sigma-Aldrich Japan K.K.) in the case of PbS quantum dots in which oleic acid was coordinated or in a deuterated DMF solvent (99.5 atom% D, manufactured by Tokyo Chemical Industry Co., Ltd.) in the case of PbS quantum dots in which iodine was coordinated, using dibromomethane (manufactured by Wako Pure Chemical Industries, Ltd.) as an internal standard substance. Measurement was performed using an NMR device (VNMRS 400, manufactured by Agilent) under the conditions of a resonance frequency of 400 MHz, a delay time of 60 seconds, and 32 times integrations. In the case of the deuterated toluene solvent, the oleic acid concentration in the PbS quantum dot solid was determined from the ratio of the integrated value of the vinyl proton of oleic acid (5.5 ppm vs. TMS) to the integrated value of the dibromomethane (3.9 ppm vs. TMS). In the case of the deuterated DMF solvent, the oleic acid concentration in the PbS quantum dot solid was determined from the ratio of the integrated value of the methyl proton (0.8 ppm vs. TMS) of oleic acid to the integrated value of the dibromomethane (3.9 ppm vs. TMS).

The atomic ratio of Pb/S/I/N in a PbS quantum dot solid was quantified by photoelectron spectroscopy (ESCA) in the PbS quantum dot solid on a glass substrate. Using an ESCA apparatus (PHI Quantera SXM, manufactured by ULVAC-PHI INC.), ESCA was measured under the conditions of X-ray source monochromatized AlKα (25 W, 15 kV), beam diameter 100 µm, measurement range 1 mm², pass energy 112 eV, step 0.2 eV, charge correction neutralizer and Ar⁺ irradiation, photoelectron take-off angle 45°, and binding energy correction C1s (284.8 eV), and the composition was determined from Pb4f, S2p, I3d, and N1s peaks.

### <Synthesis of PbS Quantum Dot Coordinated with Oleic Acid>

Into a 50 mL three-necked flask were placed 0.45 g of lead oxide (manufactured by Wako Pure Chemical Industries, Ltd.), 10 g of octadecene (manufactured by Sigma-Aldrich Japan K.K.) and 1.34 g of oleic acid (manufactured by Sigma-Aldrich Japan K.K.), and the mixture was stirred at 80°C for 2 hours to prepare a Pb source solution. After evacuating the inside of the reaction system with a vacuum pump and purging with nitrogen gas, the reaction system was further stirred at 110°C for 30 minutes. On the other hand, 210 µL of 1,1,1,3,3,3-hexamethyldisilatiane (manufactured by Tokyo Chemical Industry Co., Ltd.) was dissolved in 4 mL of octadecene to prepare an S source solution. The S source solution was injected at once with a syringe into the Pb source solution at 110°C with stirring under nitrogen gas to produce a PbS quantum dot coordinated with oleic acid. After stopping the reaction by adding a large excess of acetone, the supernatant was removed by centrifugation (CR21 GIII, R15A rotor, manufactured by Hitachi Koki K.K.) at 2,500 rpm for 2 minutes, and the precipitate was dried under reduced pressure, whereby a PbS quantum dot solid in which oleic acid was coordinated was obtained.

Each concentration in the PbS quantum dot solid in which oleic acid was coordinated was Pb=55% by mass, oleic acid=24% by mass, and oleic acid/Pb molar ratio=0.31. It was found that the Pb/S/I/N atomic ratio was 1/0.58/0/0 from the ESCA analysis results, the crystallite diameter was 3.0 nm from the X-ray diffraction result, the absorption edge wavelength was 1050 nm from the absorption spectrum, the absorption peak wavelength was 980 nm (peak absorbance 0.052 at a solid content concentration of 0.1 mg/mL in a hexane dispersion), and the emission peak wavelength was 1050 nm (excitation wavelength 800 nm) from the emission spectrum.

### <Synthesis of PbS Quantum Dot Coordinated with Iodine>

The PbS quantum dot solid (0.20 g) in which oleic acid was coordinated was dispersed in 2 mL of toluene (dehydrated, manufactured by Wako Pure Chemical Industries, Ltd.) to obtain a black transparent dispersion. Meanwhile, 0.053 g of methylamine hydroiodide (CH₃NH₃I, manufactured by Tokyo Chemical Industry Co., Ltd.) was dissolved in 0.5 mL of DMF (dehydrated, manufactured by Wako Pure Chemical Industries, Ltd.) and 1 mL of toluene (dehydrated, manufactured by Wako Pure Chemical Industries, Ltd.) (molar ratio of CH₃NH₃I/oleic acid of 2). The CH₃NH₃I solution was added dropwise to the PbS quantum dot dispersion at a drop rate of 1 drop/10 seconds (drop time: 11 minutes) at room temperature (25°C) under a nitrogen atmosphere (in a glove box) without stirring and allowed to stand for 18 hours. After further addition of 5 mL of methanol, followed by mixing, the reaction mixture was subjected to a filtration with a filter (pore size 0.2 µm, PTFE material), and then dried to obtain a PbS quantum dot solid in which iodine was coordinated.

Each concentration in the PbS quantum dot solid in which iodine was coordinated was as follows: Pb=53% by mass, oleic acid=1% by mass, and the molar ratio of oleic acid/Pb of 0.01. The Pb/S/I/N atomic ratio was 1/0.51/0.49/0 from the ESCA analysis result, the crystallite diameter was 3.5 nm from the X-ray diffraction result, the absorption edge wavelength was 1200 nm and the absorption peak wavelength was 1000 nm from the absorption spectrum of the DMF dispersion.

### <Example 1>

The following steps (1) to (7) were carried out sequentially to prepare a cell.

### (1) Etching and Cleaning of FTO Substrate

A part of a glass substrate with 25 mm square fluorine doped tin oxide (FTO) (manufactured by Asahi Glass Fabritec Corporation, 25 × 25 × 1.8 mm, hereinafter referred to as FTO substrate) was etched with Zn powder and a 2 mol/L hydrochloric acid aqueous solution. Ultrasonic cleaning was carried out for 10 minutes sequentially with 1 mass% neutral detergent, acetone, 2-propanol (IPA), and ion exchanged water.

### (2) Ozone Cleaning

Ozone cleaning of the FTO substrate was performed immediately before the compact TiO₂ layer forming step. With the FTO side facing up, the substrate was placed in an ozone generator (ozone cleaner PC-450 UV, manufactured by Meiwafosis Co., Ltd.) and irradiated with UV for 30 minutes.

### (3) Formation of Compact TiO₂ Layer (Blocking Layer)

Bis(2,4-pentanedionato)bis(2-propanolato) titanium (IV) (4.04 g, 75% IPA solution, manufactured by Tokyo Chemical Industry Co., Ltd.) was dissolved in 123.24 g of ethanol (dehydrated, manufactured by Wako Pure Chemical Industries) to prepare a spray solution. The spray solution was sprayed at a pressure of 0.3 MPa to an FTO substrate on a hot plate (450°C) from a height of about 30 cm. Spraying was repeated twice on the substrates of 20 cm × 8 rows to a spraying amount of about 7 g, and then the sprayed substrate was dried at 450°C for 3 minutes. This operation was repeated twice more to spray a total of about 21 g of the spray solution. Thereafter, the FTO substrate was immersed in an aqueous solution (50 mM) of titanium chloride (manufactured by Wako Pure Chemical Industries, Ltd.) and heated at 70°C for 30 minutes. After washing with water and drying, the FTO substrate was calcined at 500°C for 20 minutes (temperature rising: 15 minutes) to form a compact TiO₂ (cTiO₂) layer.

### (4) Formation of Mesoporous TiO₂ Layer (Porous Layer)

Ethanol (1.41 g, dehydrated, manufactured by Wako Pure Chemical Industries, Ltd.) was added to 0.404 g of an anatase form TiO₂ paste (PST-18NR, manufactured by JGC Catalysts and Chemicals Ltd.) and the mixture was subjected to ultrasonic dispersion for 1 hour to obtain a TiO₂ coating liquid. In a dry room, the TiO₂ coating liquid was spin-coated (5000 rpm × 30 sec) on the cTiO₂ layer using a spin coater (MS-100, manufactured by Mikasa Co., Ltd.). After drying for 30 minutes on a hot plate at 125°C, the cTiO₂ layer was calcined at 500°C for 30 minutes (time for temperature rising: 60 minutes) to form a mesoporous TiO₂ (mTiO₂) layer.

### (5) Formation of Light Absorption Layer

The light absorption layer and the hole transport layer were formed in a glove box. Lead iodide (PbI₂, a precursor for perovskite, 0.207 g, manufactured by Tokyo Chemical Industry Co., Ltd.), 0.072 g of methylamine hydroiodide (CH₃NH₃I, manufactured by Tokyo Chemical Industry Co., Ltd.), 0.012 g of cesium iodide (CsI, 99.999%, manufactured by Sigma-Aldrich) and 1.5 mL of DMF (dehydrated, manufactured by Wako Pure Chemical Industries, Ltd.) were mixed and stirred at room temperature to prepare a DMF solution (colorless transparent) of 0.3 mol/L perovskite (Cs_{0.1}(CH₃NH₃)_{0.9}PbI₃) raw material. Further, 0.122 g of the PbS quantum dot solid in which iodine was coordinated was added to this DMF solution, dispersed with stirring for 15 minutes, and then filtered with a PTFE filter having a pore size of 0.45 µm, thereby to obtain a mixed dispersion (coating liquid) of the PbS quantum dot and the perovskite raw material. The mass ratio (blending amount in terms of PbS) 18% of PbS to the total content of PbS and perovskite was calculated from the peak absorbance (peak wavelength: 1000 nm) of the DMF solvent-diluted dispersion of this coating liquid.

On the mTiO₂ layer, the coating liquid was spin-coated (500 rpm × 5 sec, slope 5 sec, 1000 rpm × 40 sec, slope 5 sec, 3000 rpm × 50 sec) using a spin coater (MS-100, manufactured by Mikasa Corporation). After 20 seconds from the start of spinning, 1 mL of toluene (dehydrated, manufactured by Wako Pure Chemical Industries, Ltd.) as a poor solvent was dropwise added at once to the center portion of the spin. Immediately after spin coating, the spin-coated product was dried on a 100°C hot plate for 10 minutes to form a light absorption layer. Formation of the perovskite compound was confirmed by X-ray diffraction pattern, absorption spectrum, and electron microscope observation, and the presence of the quantum dot was also confirmed from fluorescence spectrum and electron microscope observation.

### (6) Formation of Hole Transport Layer

Bis(trifluoromethanesulfonyl)imide lithium (LiTFSI, 9.1 mg, manufactured by Wako Pure Chemical Industries, Ltd.), 8.7 mg of [tris(2-(1H-pyrazol-1-yl)-4-tert-butylpyridine) cobalt(III) tris(bis(trifluoromethylsulfonyl)imide)] (Co(4-tButylpyridyl-2-1H-pyrazole) 3.3 TFSI, manufactured by Wako Pure Chemical Industries, Ltd.), 72.3 mg of 2,2',7,7'-tetrakis[N,N-di-p-methoxyphenylamino]-9,9'-spirobifluorene (Spiro-OMeTAD, manufactured by Wako Pure Chemical Industries, Ltd.), 1 mL of chlorobenzene (manufactured by Nacalai Tesque), and 28.8 µL of tert-butylpyridine (TBP, manufactured by Sigma-Aldrich) were mixed and stirred at room temperature to prepare a hole transport material (HTM) solution (black-purple transparent). Immediately before use, the HTM solution was filtered through a PTFE filter with a pore size of 0.45 µm. The HTM solution was spin-coated (4000 rpm × 30 sec) on the light absorption layer using a spin coater (MS-100, manufactured by Mikasa Co., Ltd.). Immediately after spin coating, the spin-coated product was dried on a 70°C hot plate for 30 minutes. After drying, the contact part with FTO and the entire back surface of the substrate were wiped off with a cotton swab impregnated with γ-butyrolactone (manufactured by Wako Pure Chemical Industries, Ltd.), further drying was performed on a hot plate at 70°C for several minutes, thereby forming a hole transport layer.

### (7) Deposition of Gold Electrode

Gold was deposited to a thickness of 100 nm on the hole transport layer (vacuum deposition rate: 8 to 9 Å/sec) under vacuum (4 to 5 × 10⁻³ Pa) using a vacuum vapor deposition apparatus (VTR-060M/ERH, manufactured by ULVAC KIKO Inc.) to form a gold electrode.

### <Comparative Example 1>

A light absorption layer was formed in the same manner as in Example 1 to manufacture a cell, except that, in Example 1 (5) of forming the light absorption layer, the blending amount of the PbS quantum dot solid coordinated with iodine was changed from 0.122 g to 0.085 g without adding cesium iodide, and the mass ratio (PbS converted blending amount) of PbS to the total content of PbS and perovskite (blending amount in terms of PbS) was set to 15% by mass.

**[Table 1]**

| | | | Example 1 | Comparative Example 1 |
|---|---|---|---|---|
| Perovskite (P) | Compound | | (CH₃NH₃)_{0.9}Cs_{0.1}PbI₃ | CH₃NH₃PbI₃ |
| | Monovalent cation | | CH₃NH₃⁺ and Cs⁺ | CH₃NH₃⁺ |
| | Band gap energy | (eV) | 1.6 | 1.6 |
| Quantum dot (QD) | Compound | | PbS | PbS |
| | Iodine/Pb | (Atomic ratio) | 0.49 | 0.49 |
| | Oleic acid/Pb | (Molar ratio) | 0.01 | 0.01 |
| | Particle size | (nm) | 3.5 | 3.5 |
| | Band gap energy | (eV) | 1.0 | 1.0 |
| | Blending amount in terms of PbS | (% by mass) | 18 | 15 |
| Film characteristics | Absorbance ratio (QD/P) | | 0 | 0 |
| | Absorbance of perovskite | | 0.30 | 0.22 |
| | Thickness | (nm) | 100 | 100 |
| | XRD intensity ratio of PbI₂ | (vs. perovskite) | 0.2 | 0.8 |
| | Crystalline diameter of perovskite | (nm) | 29 | 26 |
| Cell characteristics | Short-circuit current density | (mA/cm²) | 8.5 | 3.1 |
| | Open-circuit voltage | (V) | 0.56 | 0.50 |
| | Fill factor | | 0.38 | 0.40 |
| | Conversion efficiency | (%) | 1.8 | 0.66 |
| | External quantum efficiency at 500 nm | (%) | 49 | 30 |
| | External quantum efficiency ratio at 500 nm | (vs. perovskite) | 0.58 | 0.50 |
| | External quantum efficiency at 900 nm | (%) | 1.9 | 1.9 |
| | External quantum efficiency difference at 700 nm | (%) | 1.1 | Measurement is not possible due to unstable background |
| | External quantum efficiency difference at 900 nm | (%) | 0.07 | |
| | External quantum efficiency difference at 1100 nm | (%) | 0.03 | |

From Table 1, it can be seen that the light absorption layer of Example 1 using the perovskite compound containing two kinds of cations has a smaller residual amount of the perovskite raw material (PbI₂) than the light absorption layer of Comparative Example 1 using the perovskite compound containing one kind of cation and is more excellent in the photoelectric conversion efficiency. In addition, it can be understood that the light absorption layer of Example 1, wherein an external quantum efficiency difference (ΔEQE) is detected and two-stage light absorption occurs, has an intermediate-band.

### INDUSTRIAL APPLICABILITY

The light absorption layer and the photoelectric conversion element of the present invention can be suitably used as a constituent member of a next generation solar cell.

### DESCRIPTION OF REFERENCE SIGNS

- 1: Photoelectric conversion element
- 2: Transparent substrate
- 3: Transparent conductive layer
- 4: Blocking layer
- 5: Porous layer
- 6: Light absorption layer
- 7: Hole transport layer
- 8: Electrode (positive electrode)
- 9: Electrode (negative electrode)
- 10: Light

## Claims

1. A light absorption layer comprising quantum dots dispersed in a matrix of one or more perovskite compounds selected from a compound represented by the following general formula (1) and a compound represented by the following general formula (2):
RMX₃ (1)
wherein R is two or more of monovalent cations, M is a divalent metal cation, and X is a halogen anion,
R¹R²R³ₙ₋₁MₙX₃ₙ₊₁ (2)
wherein R¹, R², and R³ are each independently a monovalent cation, at least two of R¹, R², and R³ are different monovalent cations, and at least one of R¹, R², and R³ is a monovalent inorganic cation, M is a divalent metal cation, X is a halogen anion, and n is an integer of 1 or more and 10 or less.

2. The light absorption layer according to claim 1, wherein the light absorption layer has an intermediate-band.

3. The light absorption layer according to claim 1 or 2, wherein the X is a chlorine anion, a bromine anion, or an iodine anion.

4. The light absorption layer according to any one of claims 1 to 3, wherein the R is one or more selected from an alkylammonium ion and a formamidinium ion, and one or more selected from K⁺, Rb⁺, and Cs⁺.

5. The light absorption layer according to any one of claims 1 to 4, wherein the R¹ is an alkylammonium ion or a formamidinium ion, and the R² is K⁺, Rb⁺, or Cs⁺.

6. The light absorption layer according to any one of claims 1 to 5, wherein the M is Pb²⁺, Sn²⁺, or Ge²⁺.

7. The light absorption layer according to any one of claims 1 to 6, wherein a band gap energy of the quantum dot is 0.2 eV or more and is less than the band gap energy of the perovskite compound.

8. The light absorption layer according to any one of claims 1 to 7, wherein a content ratio of the quantum dot with respect to a total content of the perovskite compound and the quantum dot is 7.5% by mass or more.

9. The light absorption layer according to any one of claims 1 to 8, wherein a difference between the band gap energy of the perovskite compound and the band gap energy of the quantum dot is 0.2 eV or more and 2.0 eV or less.

10. The light absorption layer according to any one of claims 1 to 9, wherein the quantum dot includes a metal oxide or a metal chalcogenide.

11. The light absorption layer according to any one of claims 1 to 10, wherein the quantum dot contains a Pb element.

12. A dispersion for manufacturing the light absorption layer according to any one of claims 1 to 11, said dispersion comprising one or more perovskite compound selected from the compound represented by the general formula (1) and the compound represented by the general formula (2) and/or a precursor thereof, and a quantum dot containing, as a ligand, a halogen element-containing substance.

13. The dispersion according to claim 12, comprising a solvent.

14. The dispersion according to claim 12 or 13, wherein a solid content concentration of the quantum dot in the dispersion is 1 mg/mL or more and 100 mg/mL or less.

15. A light absorption layer obtained from the dispersion according to any one of claims 12 to 14.

16. A method for manufacturing a light absorption layer comprising quantum dots dispersed in a matrix of one or more perovskite compounds selected from a compound represented by the following general formula (1) and a compound represented by the following general formula (2), and including the following step 1, step 2, and step 3:
(step 1) a step of ligand-exchanging the organic ligand of an organic ligand-containing quantum dot to a halogen element-containing substance to obtain a quantum dot solid containing the halogen element-containing substance as a ligand,
(step 2) a step of obtaining a dispersion by mixing the quantum dot solid obtained in step 1 with a solution or mixed solution containing one or more substances selected from a compound represented by the following general formula (1), a compound represented by the following general formula (2), and a precursor thereof,
(step 3) a step of obtaining a light absorption layer from the dispersion obtained in step 2:
RMX₃ (1)
wherein R is two or more of monovalent cations, M is a divalent metal cation, and X is a halogen anion,
R¹R²R³ₙ₋₁MₙX₃ₙ₊₁ (2)
wherein R¹, R², and R³ are each independently a monovalent cation, at least two of R¹, R², and R³ are different monovalent cations, and at least one of R¹, R², and R³ is a monovalent inorganic cation, M is a divalent metal cation, X is a halogen anion, and n is an integer of 1 or more and 10 or less.

17. The method for manufacturing a light absorption layer according to claim 16, wherein a halogen element of the halogen element-containing substance is iodine.

18. A photoelectric conversion element having the light absorption layer according to any one of claims 1 to 11 and 15.

19. A solar cell having the photoelectric conversion element according to claim 18.
